# EUROPEAN PATENT APPLICATION

(11) **EP 4 546 421 A1**
(43) Date of publication of application: **30.04.2025**
(21) Application number: 22960372.5
(22) Date of filing: 30.09.2022
(51) Int. Cl.: H01L 23/60, H01L 27/15

(54) **LIGHT-EMITTING SUBSTRATE, BACKLIGHT MODULE, AND DISPLAY DEVICE**

(71) Applicant: BOE Technology Group Co., Ltd., Beijing 100015 (CN); Hefei BOE Ruisheng Technology Co., Ltd., Xinzhan General Pilot Zone Hefei, Anhui 230012 (CN)
(72) Inventor: SUN, Yiding, Beijing 100176 (CN); ZHANG, Bing, Beijing 100176 (CN); GAO, Liang, Beijing 100176 (CN); WANG, Kangli, Beijing 100176 (CN); KANG, Ping, Beijing 100176 (CN); XU, Jiawei, Beijing 100176 (CN); XU, Zouming, Beijing 100176 (CN); LI, Youlu, Beijing 100176 (CN); WANG, Bing, Beijing 100176 (CN); WANG, Jie, Beijing 100176 (CN); WU, Xintao, Beijing 100176 (CN); LUO, Ningyu, Beijing 100176 (CN); HAN, Tingwei, Beijing 100176 (CN)
(74) Representative: Hoffmann Eitle
(86) International application number: PCT/CN2022/123478
(87) International publication number: WO 2024/065759

(57) **Abstract**

A light-emitting substrate (100), provided with a functional area (F) and a binding area (B). The binding area (B) and the functional area (F) are sequentially arranged in a first direction. The light-emitting substrate (100) comprises: a base (110); a plurality of functional element groups (120) located on one side of the base (110), the plurality of functional element groups (120) being located in the functional area (F); and a first electrostatic path (130) located on the same side of the base (110) as the plurality of functional element groups (120), the first electrostatic path (130) being electrically connected to the binding area (B), a part of the first electrostatic path (130) being located in the functional area (F), and the first electrostatic path (130) being configured to direct static electricity from the functional area (F) to the binding area (B).

## Description

### TECHNICAL FIELD

The present disclosure relates to the field of display technologies, and in particular, to a light-emitting substrate, a backlight module, and a display apparatus.

### BACKGROUND

Light-emitting diodes (LEDs), mini light-emitting diodes (Mini LEDs) or micro light-emitting diodes (Micro LEDs) are active self-luminous devices. A size of the Mini LED is about 80 µm to 500 µm, and a size of the Micro LED is about less than 80 µm.

Mini LEDs may be used in backlight and direct display, and generally used for backlight applications. With a dense distribution of a large number of Mini LEDs, local dimming in smaller regions can be achieved, which can achieve better brightness uniformity and higher color contrast within a smaller light-mixing distance in comparison with the traditional backlight design, thereby achieving ultra-thin, high color rendering and power saving of the terminal product. Meanwhile, as Mini LEDs can be designed on a flexible substrate, in cooperation with a curved liquid crystal display (LCD) panel, a curved display similar to a curved display of an organic light-emitting diode (OLED) may be achieved in a case of ensuring image quality.

Micro LEDs are generally used for RGB direct display applications, which can overcome the wiring bonding and reliability defects of formal chips. In combination with the advantages of COB (chip on board) or COG (chip on glass) packaging, Micro LEDs make it possible to further reduce the dot pitch of the display screen, so that the visual effect of the corresponding terminal product is greatly improved, and the viewing distance can be greatly reduced, allowing indoor display screens to further replace the original LCD market. Furthermore, Micro LEDs are combined with flexible substrates, which can achieve high quality image display effects of the curved display; and in addition, due to the self-luminous characteristic of the Micro LEDs, the Micro LEDs have a very broad market in some special modeling requirements (such as automotive displays).

### SUMMARY

In an aspect, a light-emitting substrate is provided, which has a functional area and a bonding area. The bonding area and the functional area are arranged along a first direction in sequence. The light-emitting substrate includes a substrate, a plurality of functional element groups, and a first electrostatic pathway. The plurality of functional element groups are located on a side of the substrate and located in the functional area. The first electrostatic pathway is located on a same side of the substrate with the plurality of functional element groups. The first electrostatic pathway is electrically connected to the bonding area, a portion of the first electrostatic pathway is located in the functional area, and the first electrostatic pathway is configured to conduct static electricity from the functional area to the bonding area.

In some embodiments, the first electrostatic pathway includes a first annular conductive structure and at least one first conductive pattern; the first annular conductive structure includes a first sub-segment, a second sub-segment and a third sub-segment that are electrically connected in sequence; the first sub-segment and the second sub-segment are located on opposite sides of the functional area along a second direction, and the third sub-segment is located on a side of the functional area away from the bonding area; at least a portion of a first conductive pattern is located in the functional area, and an orthographic projection of the first conductive pattern on the substrate does not overlap with orthographic projections of the functional element groups on the substrate; the first conductive pattern is electrically connected to the third sub-segment; and the first direction intersects with the second direction.

In some embodiments, in a case where there are a plurality of first conductive patterns, in the first direction, two adjacent first conductive patterns are electrically connected, and a first conductive pattern closest to the third sub-segment is electrically connected to the third sub-segment.

In some embodiments, the plurality of first conductive patterns and the first annular conductive structure are made of a same material and arranged in a same layer; and the third sub-segment and the first conductive pattern electrically connected to the third sub-segment form a one-piece structure.

In some embodiments, the first electrostatic pathway further includes a plurality of bridge portions; in any column of first conductive patterns, two adjacent first conductive patterns are electrically connected through a bridge portion.

In some embodiments, at least one of the plurality of bridge portions is a jumper resistor.

In some embodiments, a functional element group includes a driver chip and at least one light-emitting device group, and a light-emitting device group includes at least two light-emitting devices; the light-emitting substrate further includes a first connection line connecting the driver chip to the light-emitting device group and a second connection line connecting any two light-emitting devices belong to a same light-emitting device group; orthographic projections of the plurality of first conductive patterns on the substrate do not overlap with orthographic projections of the first connection line and the second connection line on the substrate.

**In** some embodiments, the plurality of first conductive patterns, the first connection line and the second connection line are made of a same material and arranged in a same layer.

**In** some embodiments, first electrostatic pathway includes a plurality of first voltage lines and at least one third connection line, the plurality of first voltage lines extend along the first direction and arranged at intervals along a second direction, and a third connection line is used to connect at least two first voltage lines.

**In** some embodiments, the third connection line is located on a side of the functional area away from the bonding area.

**In** some embodiments, along the second direction, a (2i-1)-th first voltage line and a 2i-th first voltage line are connected to a same third connection line, and i is a positive integer.

**In** some embodiments, functional element groups arranged along the first direction are connected to one first voltage line.

**In** some embodiments, in a case where there are a plurality of third connection lines, the plurality of third connection lines are connected to form a one-piece structure.

**In** some embodiments, the plurality of first voltage lines and the plurality of third connection lines are made of a same material and arranged in a same layer.

**In** some embodiments, the plurality of functional element groups are arranged in columns; the functional area includes a plurality of device regions, and a single functional element group is located in one device region; the first electrostatic pathway includes a plurality of second voltage lines and a plurality of second conductive patterns. A second voltage line is electrically connected to a column of functional element groups. Orthographic projections of the plurality of second conductive patterns on the substrate do not overlap with orthographic projections of the functional element groups on the substrate. A second conductive pattern is electrically connected to the second voltage line, and at least a portion of the second conductive pattern is located in the device region.

In some embodiments, the plurality of second voltage lines and the plurality of second conductive patterns are made of a same material and arranged in a same layer.

In some embodiments, the light-emitting substrate further includes a plurality of functional pins and a second electrostatic pathway; the plurality of functional pins are located in the bonding area; the second electrostatic pathway is a second annular conductive structure surrounding the functional area, and the second annular conductive structure includes a first sub-portion, a second sub-portion, a third sub-portion and a fourth sub-portion that are electrically connected in sequence; the first sub-portion and the second sub-portion are located on opposite sides of the functional area along a second direction, the third sub-portion is located on a side of the functional area away from the bonding area, and a portion of the fourth sub-portion is located on a side of the bonding area away from the functional area; and the second electrostatic pathway is configured to conduct static electricity from the functional area to the bonding area. The plurality of functional pins are electrically connected to the portion of the fourth sub-portion located on the side of the bonding area away from the functional area.

In some embodiments, the light-emitting substrate further includes a plurality of second voltage signal pin groups, a plurality of first voltage signal pin groups and a plurality of dummy pins that are located in the bonding area, a second voltage signal pin groups includes a plurality of second voltage signal pins, and a first voltage signal pin groups includes a plurality of first voltage pins.

In some embodiments, at least one dummy pin is electrically connected to the portion of the fourth sub-portion located on the side of the bonding area away from the functional area.

In some embodiments, the plurality of first voltage signal pin groups and the plurality of second voltage signal pin groups are alternately arranged along the second direction, and at least one dummy pin is disposed between any adjacent first voltage signal pin group and second voltage signal pin group.

In some embodiments, in the first direction, a distance between a dummy pin electrically connected to the fourth sub-portion and the second voltage signal pins of a second voltage signal pin group adjacent to the dummy pin is greater than or equal to 200 µm.

In some embodiments, a distance between two adjacent first voltage signal pins is greater than or equal to 100 µm.

In some embodiments, the second electrostatic pathway, the plurality of functional pins, the plurality of dummy pins, the plurality of second voltage signal pin groups and the plurality of first voltage signal pin groups are made of a same material and arranged in a same layer.

In another aspect, a backlight module is provided, which includes the light-emitting substrate as described in any one of the above embodiments and an optical film provided on a light-exit surface of the light-emitting substrate.

In yet another aspect, a display apparatus is provided, which includes the backlight module as described in the above embodiment, an array substrate disposed on a light-exit surface of the backlight module, and a color filter substrate disposed on a side of the array substrate away from the backlight module.

### BRIEF DESCRIPTION OF THE DRAWINGS

In order to describe technical solutions in the present disclosure more clearly, the accompanying drawings to be used in some embodiments of the present disclosure will be introduced briefly. Obviously, the accompanying drawings to be described below are merely drawings of some embodiments of the present disclosure, and a person of ordinary skill in the art can obtain other drawings according to these drawings. In addition, the accompanying drawings to be described below may be regarded as schematic diagrams, but are not limitations on actual sizes of products and actual processes of methods involved in the embodiments of the present disclosure.
FIG. 1a is a structural diagram of a display apparatus, in accordance with some embodiments of the present disclosure.
FIG. 1b is a structural diagram of another display apparatus, in accordance with some embodiments of the present disclosure.
FIG. 2 is a structural diagram of a backlight module, in accordance with some embodiments of the present disclosure.
FIG. 3a is a schematic diagram showing a discharging current and a discharging time of a light-emitting substrate for human body model and charged device model.
FIG. 3b is a schematic diagram showing an arrangement of an anti-static ring, driver chips and light-emitting devices in a light-emitting substrate, in accordance with an implementation.
FIG. 3c is a schematic diagram showing a process of static electricity of charged device model generated during a film attaching process of a light-emitting substrate.
FIG. 3d is a schematic diagram of static electricity of charged device model accumulated on the light-emitting substrate corresponding to FIG. 3c.
FIG. 3e is a schematic diagram showing an electrostatic breakdown phenomenon of static electricity of charged device model on a light-emitting substrate, in accordance with an implementation.
FIG. 4 is a structural diagram of a light-emitting substrate, in accordance with some embodiments of the present disclosure.
FIG. 5 is a structural diagram of a first electrostatic pathway, in accordance with some embodiments of the present disclosure.
FIG. 6 is a structural diagram of another light-emitting substrate, in accordance with some embodiments of the present disclosure.
FIG. 7 is a structural diagram of another first electrostatic pathway, in accordance with some embodiments of the present disclosure.
FIG. 8 is a structural diagram of yet another first electrostatic pathway, in accordance with some embodiments of the present disclosure.
FIG. 9a is a schematic diagram showing a conducting path of static electricity in a light-emitting substrate, in accordance with an implementation.
FIG. 9b is a schematic diagram showing an actual product of light-emitting devices with poor lighting, in accordance with an implementation.
FIG. 9c is a schematic diagram showing a conducting path of static electricity in a light-emitting substrate, in accordance with some embodiments of the present disclosure.
FIG. 10 is a partial structural diagram of a first electrostatic pathway, in accordance with some embodiments of the present disclosure.
FIG. 11 is a structural diagram of a second electrostatic pathway, in accordance with some embodiments of the present disclosure.
FIG. 12a is a structural diagram of another second electrostatic pathway, in accordance with some embodiments of the present disclosure.
FIG. 12b is a partial structural diagram of the region B1 in FIG. 12a.
FIG. 12c is another partial structural diagram of the region B1 in FIG. 12a.
FIG. 12d is a partial structural diagram of the region B2 in FIG. 12a.
FIG. 12e is another partial structural diagram of the region B2 in FIG. 12a.
FIG. 12f is a partial structural diagram of the region B3 in FIG. 12a.
FIG. 13 is a structural diagram of yet another light-emitting substrate, in accordance with some embodiments of the present disclosure.
FIG. 14 is a flowchart of manufacturing a light-emitting substrate, in accordance with some embodiments of the present disclosure.
FIG. 15 is a structural diagram of yet another light-emitting substrate, in accordance with some embodiments of the present disclosure.
FIG. 16 is a comparison chart of the anti-static ability of light-emitting substrates adopting different structural designs, in accordance with some embodiments of the present disclosure.

### DETAILED DESCRIPTION

The technical solutions in some embodiments of the present disclosure will be described clearly and completely below with reference to the accompanying drawings, and obviously, the described embodiments are merely some but not all embodiments of the present disclosure. All other embodiments obtained by a person of ordinary skill in the art based on the embodiments provided in the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

In the following, the terms "first" and "second" are used for descriptive purposes only, and are not to be construed as indicating or implying the relative importance or implicitly indicating the number of indicated technical features. Thus, a feature defined with "first" or "second" may explicitly or implicitly include one or more of the features. In the description of the embodiments of the present disclosure, the term "a/the plurality of" means two or more unless otherwise specified.

In the description of some embodiments, the term "connected" and derivatives thereof may be used. The term "connected" should be understood in a broad sense. For example, the term "connected" may represent a fixed connection, a detachable connection, or a one-piece connection, or may represent a direct connection, or may represent an indirect connection through an intermediate medium. For example, the term "connected" may be used in the description of some embodiments to indicate that two or more components are in direct physical or electrical contact with each other. The embodiments disclosed herein are not necessarily limited to the content herein.

The phrase "A and/or B" includes the following three combinations: only A, only B, and a combination of A and B.

As used herein, the term "if" is, optionally, construed as "when" or "in a case where" or "in response to determining that" or "in response to detecting", depending on the context. Similarly, depending on the context, the phrase "if it is determined that" or "if [a stated condition or event] is detected" is optionally construed as "in a case where it is determined that" or "in response to determining that" or "in a case where [the stated condition or event] is detected" or "in response to detecting [the stated condition or event]".

The phrase "applicable to" or "configured to" used herein means an open and inclusive expression, which does not exclude devices that are applicable to or configured to perform additional tasks or steps.

In addition, the phrase "based on" used is meant to be open and inclusive, since a process, step, calculation or other action that is "based on" one or more of the stated conditions or values may, in practice, be based on additional conditions or values other than those stated.

The term such as "about", "substantially", or "approximately" as used herein includes a stated value and an average value within an acceptable range of deviation of a particular value. The acceptable range of deviation is determined by a person of ordinary skill in the art, considering measurement in question and errors associated with measurement of a particular quantity (i.e., limitations of a measurement system).

The term such as "perpendicular" or "equal" as used herein includes a stated condition and a condition similar to the stated condition within an acceptable range of deviation. The acceptable range of deviation is determined by a person of ordinary skill in the art, considering measurement in question and errors associated with measurement of a particular quantity (i.e., limitations of a measurement system). For example, the term "perpendicular" includes absolute perpendicularity and approximate perpendicularity, and an acceptable range of deviation of the approximate perpendicularity may be, for example, a deviation within 5°. The term "equal" includes absolute equality and approximate equality, and an acceptable range of deviation of the approximate equality may be, for example, a difference between two equals being less than or equal to 5% of either of the two equals.

It will be understood that, in a case where a layer or element is referred to as being on another layer or substrate, it may be that the layer or element is directly on the another layer or substrate, or there may be an intermediate layer between the layer or element and the another layer or substrate.

Exemplary embodiments are described herein with reference to sectional views and/or plan views as idealized exemplary drawings. In the accompanying drawings, thickness of layers and sizes of regions are enlarged for clarity. Thus, variations in shapes with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in an apparatus, and are not intended to limit the scope of the exemplary embodiments.

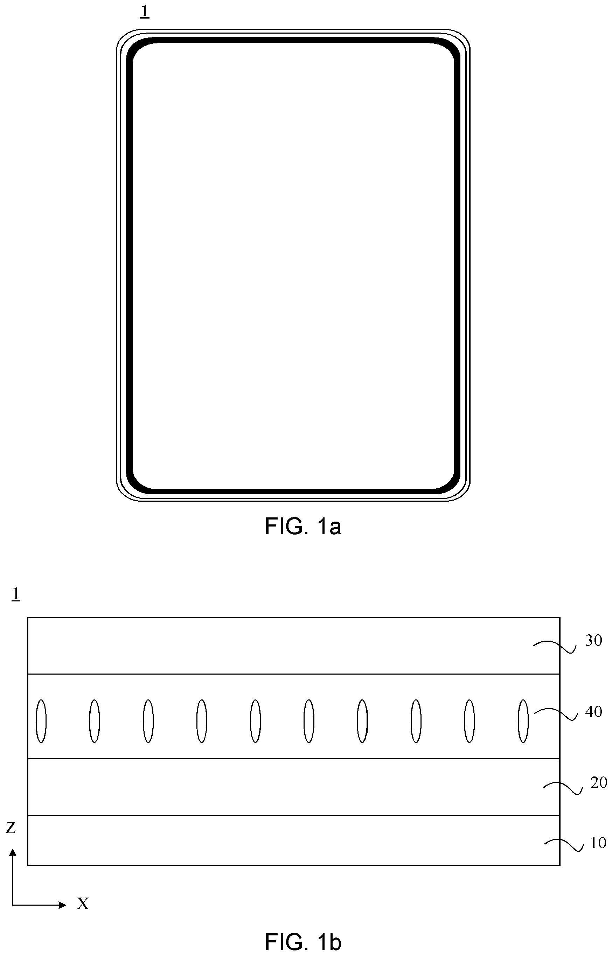

Some embodiments of the present disclosure provide a display apparatus 1. As shown in FIG. 1a, the display apparatus 1 may be any apparatus that displays images whether in motion (e.g., videos) or stationary (e.g., static images), and whether textual or graphical. More specifically, it is expected that the display apparatus in the embodiments may be implemented in or associated with a variety of electronic apparatuses. The variety of electronic apparatuses may include (but are not limit to), for example, mobile phones, wireless apparatuses, personal data assistants (PDAs), hand-held or portable computers, GPS receivers/navigators, cameras, MP4 video players, video cameras, game consoles, watches, clocks, calculators, TV monitors, flat panel displays, computer monitors, car displays (such as odometer displays), navigators, cockpit controllers and/or displays, camera view displays (such as rear view camera displays in vehicles), electronic photos, electronic billboards or indicators, projectors, building structures, packagings and aesthetic structures (such as a display for an image of a piece of jewelry), etc.

For example, in a case where the display apparatus 1 is a large-size display apparatus, the display apparatus 1 may include a plurality of display sub-apparatuses, and the plurality of display sub-apparatuses are tiled to each other to form the large-size display apparatus, so as to meet the large-size display requirement. This display apparatus may be called a tiled display apparatus.

In some examples, the display apparatus 1 may be a liquid crystal display (LCD) apparatus.

In some examples, as shown in FIG. 1b, the display apparatus 1 includes a backlight module 10, an array substrate 20 disposed on a light-exit surface of the backlight module 10, and a color filter substrate 30 disposed on a side of the array substrate 20 away from the backlight module 10.

For example, the backlight module 10 may be used as a light source to provide backlight. For example, the backlight provided by the backlight module 10 may be white light or blue light.

For example, the light-exit surface of the backlight module 10 refers to a surface of the backlight module 10 where light is emitted.

For example, the array substrate 20 may include a plurality of pixel driving circuits and a plurality of pixel electrodes. The plurality of pixel driving circuits are arranged, for example, in an array. The plurality of pixel driving circuits are electrically connected to the plurality of pixel electrodes in a one-to-one correspondence, and the pixel driving circuits provide pixel voltages for respective pixel electrodes.

For example, the color filter substrate 30 may include a variety of color filters. For example, in a case where the backlight provided by the backlight module 10 is white light, the color filters may include red filters, green filters, and blue filters. For example, the red filter can only transmit red light in the incident light, the green filter can only transmit green light in the incident light, and the blue filter can only transmit blue light in the incident light. For another example, in a case where the backlight provided by the backlight module 10 is blue light, the color filters may include red filters and green filters.

For example, the color filter substrate 30 further includes a common electrode. The common electrode can receive a common voltage. In other cases, the common electrode may also be disposed in the array substrate 20, which is not limited in the present disclosure.

In some examples, as shown in FIG. 1b, the display apparatus 1 further includes a liquid crystal layer 40 located between the color filter substrate 30 and the array substrate 20.

For example, the liquid crystal layer 40 includes a plurality of liquid crystal molecules. For example, an electric field may be formed between the pixel electrode and the common electrode, and the liquid crystal molecules located between the pixel electrode and the common electrode may be deflected under the action of the electric field.

It can be understood that the backlight provided by the backlight module 10 can pass through the array substrate 20 and be incident on the liquid crystal molecules of the liquid crystal layer 40. The liquid crystal molecules are deflected under the action of the electric field formed between the pixel electrode and the common electrode, so that the amount of light passing through the liquid crystal molecules is changed, which makes the light passing through the liquid crystal molecules reach a preset luminance. The light passes through the filters of different colors in the color film substrate 30 and then exits. The exited light includes light of various colors, such as red light, green light, and blue light, and the light of various colors cooperate with each other to enable the display apparatus 1 to achieve display.

For example, a type of the backlight module 10 in the display apparatus 1 varies, which can be set according to actual conditions, and there is no limit in the present disclosure.

For example, the backlight module 10 may be an edge-lit backlight module, or the backlight module 10 may be a backlit backlight module.

For convenience of description, the following embodiments of the present disclosure are introduced by taking an example in which the backlight module 10 is the backlit backlight module.

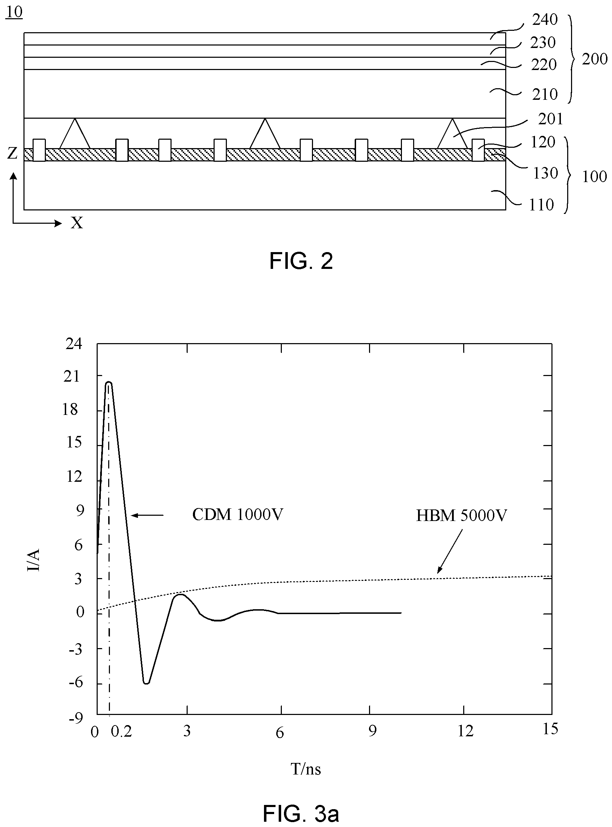

In some embodiments, as shown in FIG. 2, the backlight module 10 includes a light-emitting substrate 100 and an optical film 200 disposed at a light-exit surface of the light-emitting substrate 100.

It can be understood that Z in FIG. 2 refers to a third direction Z, and the third direction Z is a thickness direction of the display apparatus 1.

For example, the optical film 200 includes a diffusion plate 210, a quantum dot film 220, a diffusion sheet 230 and a composite film 240 that are stacked in sequence at the light-exit surface of the light-emitting substrate 100.

For example, the diffusion plate 210 and the diffusion sheet 230 are used to eliminate lamp shadows and uniformize light emitted by the light-emitting substrate 100 to improve the light uniformity.

For example, the quantum dot film 220 is used to convert the light emitted by the light-emitting substrate 100. Optionally, in a case where the light emitted by the light-emitting substrate 100 is blue light, the quantum dot film 220 can convert the blue light into white light and improve the purity of the white light.

For example, the composite film 240 is used to increase the luminance of the light emitted by the light-emitting substrate 100.

It can be understood that the luminance of the light emitted by the light-emitting substrate 100 is enhanced after being incident on and then exiting through the optical film 200, and the exited light has a relatively high purity and a relatively good uniformity.

The backlight module 10 can include a plurality of light-emitting substrates 100 and respective optical films; the plurality of light-emitting substrates 100 can be tiled to each other, and the respective optical films can also be tiled to each other, so that the backlight module 10 has a relatively large size. In this case, the backlight module 10 may be called a tiled display module, and may be applied to the above-mentioned tiled display apparatus.

In some examples, as shown in FIG. 2, the backlight module 10 further includes supporting columns 201 disposed between the light-emitting substrate 100 and the diffusion plate 210 of the optical film 200.

For example, the supporting columns 201 may be fixed on the light-emitting substrate 100 by adhesive. The supporting columns 201 may be used to support the optical film 200 and enable the light emitted by the light-emitting substrate 100 to have a certain light-mixing distance, thereby further eliminating lamp shadows and improving light uniformity.

For example, the display apparatus 1 further includes a frame, a display chip and other electronic elements.

In some other examples, the display apparatus 1 includes a light-emitting substrate 100, and the light-emitting substrate 100 is used to directly display images. This display apparatus is generally used in commercial display, which is, for example, a display screen of the traffic management and command center or a display screen of the commercial plaza.

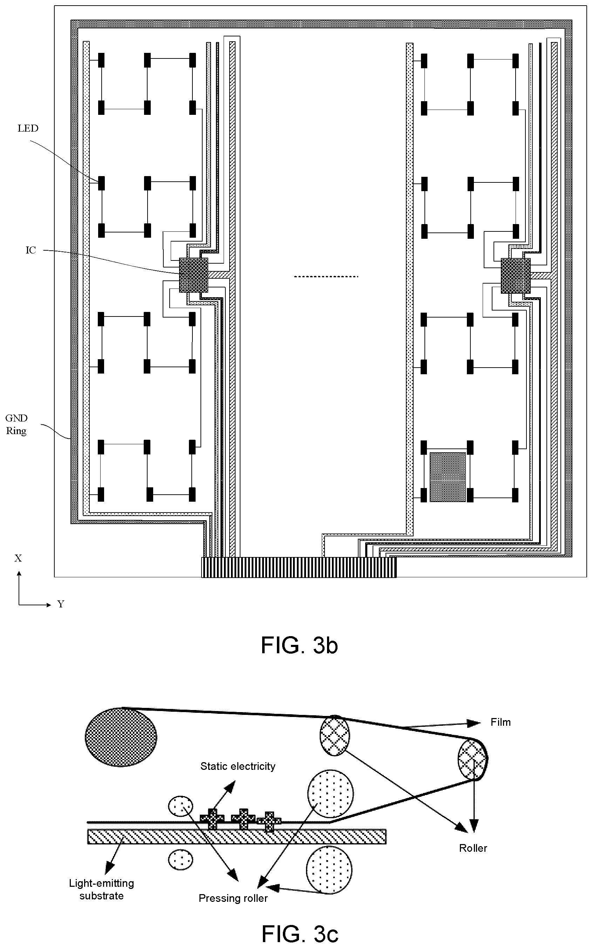

It can be understood that, during the use of the light-emitting substrate, it is inevitable for the light-emitting substrate to be in contact with the human body. After the human body carries a certain amount of static electricity due to friction or other reasons, in a case where the human body is in contact with the light-emitting substrate, the static electricity is conducted to the light-emitting substrate and discharged through the light-emitting substrate. In this case, the discharge model is the human body model (HBM). The equivalent resistance of the human body is 1500 Ω, and after the human body is in contact with the light-emitting substrate, the characteristics of the electrostatic discharge in the light-emitting substrate are that (as shown in FIG. 3a) the discharge time is long, the peak current is relatively small, and extremely high instantaneous discharge current may be generated within hundreds of nanoseconds, which may reach several amperes. At present, there are many design solutions for the electrostatic discharge of HBM. One of implementations is to provide an anti-static ring at the edge of the light-emitting substrate, so as to reduce the static electricity that enters the light-emitting substrate from the edge of the light-emitting substrate and to avoid the discharge of HBM. FIG. 3b shows a relative arrangement of various signal lines, driver chips IC and light-emitting devices (LEDs) in the light-emitting substrate in the implementation, and the GND Ring is the anti-static ring that surrounds the periphery of the driver chips IC and the LEDs.

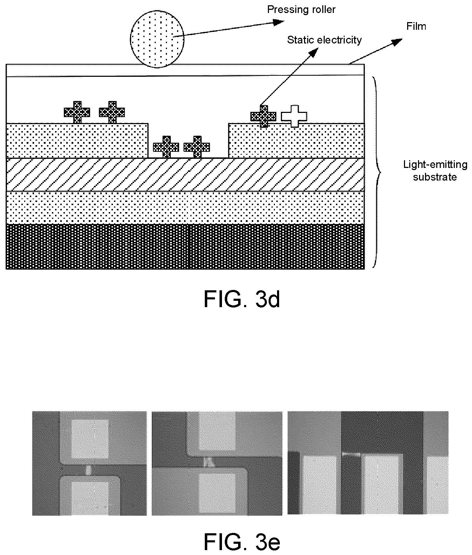

In addition, the manufacturing process of the light-emitting substrate generally includes an assembly or transportation process of the light-emitting substrate. For example, during the film attaching process of the light-emitting substrate, the light-emitting substrate will be in contact with other charged conductors, and the static electricity on the charged conductors will be conducted to the light-emitting substrate, resulting in charging and discharging phenomena. The charge and discharge model generated during the manufacturing process is the charged device model (CDM). The discharge characteristics of the CDM are that the rise time of the discharge current is short, which is about 0.2 ns to 0.4 ns, and the duration is 6 ns to 8 ns, but the current peak value is extremely large, which is about 15 times to 20 times that of the HBM under the same static electricity. By comparing the pulse of the CDM with an empirical electrostatic value of 1000 V and the pulse of the HBM with an empirical electrostatic value of 5000 V (as shown in FIG. 3a), it can be seen that the rise time of the CDM is about 0.2 ns, and the current can reach up to about 21 A. If this large current and rapid discharge pulse leakage occur in the light-emitting substrate, the internal circuits of the light-emitting substrate are easily damaged, and the damage is generally concentrated in a bonding area of the light-emitting substrate and on a side of a functional area away from the bonding area. For example, the charge and discharge model of the static electricity generated during the film attaching process and conducted to the light-emitting substrate is the CDM. As shown in FIGS. 3c and 3d, in this process, the roller (the roller is generally made of a metal material) that transports the film and the pressing roller (the roller is generally made of a silicone material) used to attach the film will constantly have frictions during the contacting process with the film, so that a large amount of static electricity is generated. After the film carrying the static electricity is attached to the light-emitting substrate, the static electricity will enter the light-emitting substrate. As shown in FIG. 3e, when the static electricity accumulates to a certain extent in the light-emitting substrate, the static electricity will cause breakdown and discharge of the pad capacitor (the capacitor composed of two adjacent pads) of the light-emitting substrate or the adjacent pin capacitor (the capacitor composed of two adjacent pins) of the light-emitting substrate, resulting in damage to the pad of the light-emitting substrate and affecting the function of the light-emitting substrate. This damage mainly occurs in the area where the electronic elements are located, and the electronic elements are on the side of the functional area away from the bonding area (i.e., the sky side of the light-emitting substrate). Since the degree of damage to the light-emitting substrate caused by the CDM is much greater than that caused by the HBM, the anti-static design solution based on the HBM is not suitable for the CDM.

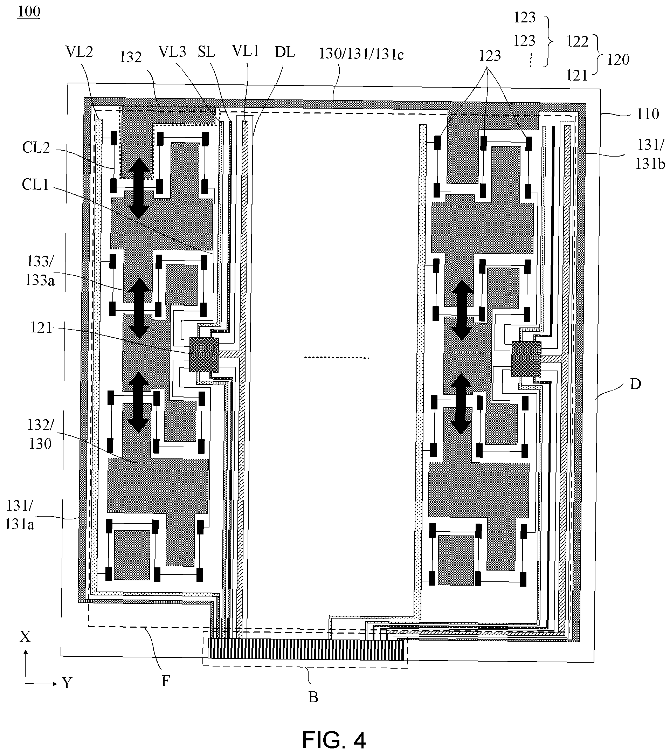

Based on this, the present disclosure provides a light-emitting substrate 100. As shown in FIG. 4, the light-emitting substrate 100 has a functional area F and a bonding area B. The bonding area B and the functional area F are arranged in sequence along a first direction X.

For example, the bonding area B is an area where the light-emitting substrate 100 and a display chip are bonded.

For example, a shape of the functional area B varies, which can be selected according to actual situations, and the present disclosure does not limit this.

For example, the shape of the functional area F may be rectangular or circular.

For convenience of illustration, the following introduction is made with an example in which the shape of the functional area F is rectangular.

In some examples, the light-emitting substrate 100 includes a substrate 110 and a plurality of functional element groups 120.

In some examples, the substrate 110 may be a flexible substrate. The flexible substrate may be, for example, a polyethylene terephthalate (PET) substrate, a polyethylene naphthalate two formic acid glycol ester (PEN) substrate, a polyimide (PI) substrate.

In some other examples, the substrate 110 may be a rigid substrate. For example, the material of the substrate may be glass. The substrate 110 may also be a printed circuit board (PCB), an aluminum substrate.

For example, the functional element groups 120 are located on a side of the substrate 110, and the functional element groups 120 are located in the functional area F.

In some examples, a functional element group 120 may include a plurality of micro-resistors, a plurality of micro-capacitors.

In some other examples, the functional element group 120 may include a driver chip 121 and at least one light-emitting device group 122. A light-emitting device group 122 includes at least two light-emitting devices 123.

For example, the functional element group 120 may include the driver chip 121 and one light-emitting device group 122.

For another example, the functional element group 120 may include the driver chip 121 and a plurality of light-emitting device groups 122.

For example, the light-emitting device group 122 may include two light-emitting devices 123, four light-emitting devices 123, or six light-emitting devices 123.

For example, at least two light-emitting devices 123 in a same light-emitting device group 122 are connected to each other in series.

For example, under the control of a driving signal transmitted by the driver chip 121, the light-emitting device group 122 emits light.

For example, the light-emitting device 123 may be a mini light-emitting diode (Mini LED). Since the grain size of the Mini LED is small, the light-mixing distance between adjacent Mini LEDs can be greatly reduced. Thus, the light-emitting substrate has advantages of adjustable regional luminance, high color rendering and high contrast, and the light-emitting substrate also has a small thickness and light weight, and low power consumption; and in turn, the application of the light-emitting substrate including Mini LEDs is more flexible. Furthermore, compared with the organic light-emitting diode (OLED), the light-emitting substrate including Mini LEDs has lower cost, longer service life and less risk of screen burn-in.

For convenience of description, the following will be introduced by taking an example in which the functional element group 120 includes a driver chip 121 and at least one light-emitting device group 122.

In some examples, as shown in FIG. 4, the light-emitting substrate 100 further includes a first electrostatic pathway 130.

For example, the first electrostatic pathway 130 and the functional element groups 120 are located on a same side of the substrate 110, the first electrostatic pathway 130 is connected to the bonding area B, and a portion of the first electrostatic pathway 130 is located in the functional area F. The first electrostatic pathway 130 is configured to conduct static electricity from the functional area F to the bonding area B.

For example, the static electricity accumulated on the functional element group 120 in the functional area F can be conducted to the portion of the first electrostatic pathway 130 located in the functional area F, and then conducted to the bonding area B through the first electrostatic pathway 130, which prevents static electricity from being charged and discharged in the functional area F, and in turn, avoids affecting the function of the functional element group 120.

In the embodiments of the present disclosure, the first electrostatic pathway 130 is arranged in the light-emitting substrate 100, the first electrostatic pathway 130 and the plurality of functional element groups are located on the same side of the substrate 110, the first electrostatic pathway 130 is connected to the bonding area B, and a portion of the first electrostatic pathway 130 is located in the functional area F. Thus, the static electricity in the functional area F of the light-emitting substrate may be conducted to the bonding area B through the first electrostatic pathway 130, so as to avoid charging and discharging of the static electricity generated during the manufacturing process of the light-emitting substrate 100, and to avoid affecting the functions of the functional element groups 120 and the light-emitting substrate 100.

It can be understood that, the first electrostatic pathway 130 can be arranged in a variety of ways, and can be arranged according to actual needs, and the present disclosure does not limit this.

In some embodiments, as shown in FIG. 4, the first electrostatic pathway 130 includes a first annular conductive structure 131 and at least one first conductive pattern 132. The first annular conductive structure 131 includes a first sub-segment 131a, a second sub-segment 131b and a third sub-segment 131c that are electrically connected in sequence. The first sub-segment 131a and the second sub-segment 131b are located on opposite sides of the functional area F along a second direction Y, and the third sub-segment 131c is located on a side of the functional area F away from the bonding area B. At least a portion of the first conductive pattern 132 is located in the functional area B.

For example, the first electrostatic pathway 130 includes the first annular conductive structure 131 and one first conductive pattern 132.

For another example, the first electrostatic pathway 130 includes the first annular conductive structure 131 and a plurality of first conductive patterns 132.

In the case where there are the plurality of first conductive patterns 132, the plurality of first conductive patterns 132 are arranged in an array. For example, the plurality of first conductive patterns 132 are arranged in multiple rows along the first direction X, and arranged in multiple columns along the second direction Y.

For example, the first annular conductive structure 131 may be an irregular ring, which may be a portion of a ring.

In the case where the functional area F is rectangular, the first annular conductive structure 131 is a part of a rectangular ring.

For example, the third sub-segment 131c is located on the side of the functional area F away from the bonding area B, which means that the third sub-segment 131c is located on the sky side of the light-emitting substrate 100.

For example, the light-emitting substrate 100 further has a peripheral area D, and the peripheral area D surrounds the functional area F.

For example, the first sub-segment 131a, the second sub-segment 131b and the third sub-segment 131c in the first annular conductive structure 131 may be located in the peripheral area D.

For example, a portion of the first conductive pattern 132 is located in the functional area B, and another portion of the first conductive pattern 132 is located in the peripheral area D.

For another example, the entire first conductive pattern 132 is located in the functional area B.

**In** some examples, an orthographic projection of the first conductive pattern 132 on the substrate 110 does not overlap with an orthographic projection of the functional element group 120 on the substrate 110.

For example, there is no overlapping between the orthographic projection of the first conductive pattern 132 on the substrate 110 and the orthographic projection of the functional element group 120 on the substrate 110, and a border of the orthographic projection of the first conductive pattern 132 on the substrate 110 does not intersect with a border of the orthographic projection of the functional element group 120 on the substrate 110.

For example, the first conductive pattern 132 is located in a gap area between multiple adjacent functional element groups 120.

For example, the first direction X intersects with the second direction Y.

For example, an included angle between the first direction X and the second direction Y may be 80°, 85°, 90° or 95°.

**In** some examples, a first conductive pattern 132 is electrically connected to the third sub-segment 131c.

For example, in the case where there are the plurality of first conductive patterns 132 and the plurality of first conductive patterns 132 are arranged in multiple rows along the first direction X, an end of each first conductive pattern 132 in a row of first conductive patterns 132 closest to the third sub-segment 131c is electrically connected to the third sub-segment 131c; and for each first conductive pattern 132 in the row of first conductive patterns 132, a portion of which is located in the functional area **F,** and another portion of which is located in the peripheral area D.

With the above arrangement, in the case that static electricity accumulates during the manufacturing process of the light-emitting substrate, the static electricity will be conducted through at least one first conductive pattern 132 to the third sub-segment 131c to which the at least one first conductive pattern 131b is electrically connected, then conducted to the first sub-segment 131a or the second sub-segment 131b, and thus conducted to the bonding area B. As a result, the static electricity in the light-emitting substrate is conducted from the functional area F to the bonding area B, which prevents the static electricity from accumulating in the functional area F, avoids damage to the light-emitting devices 123 or the driver chip 121 in the functional element group 120 caused by the accumulation of static electricity to a certain extent, and thereby avoids affecting the function of the functional element group 120. Thus, the anti-static ability of the light-emitting substrate is improved, and the yield of manufacturing the light-emitting substrate is increased.

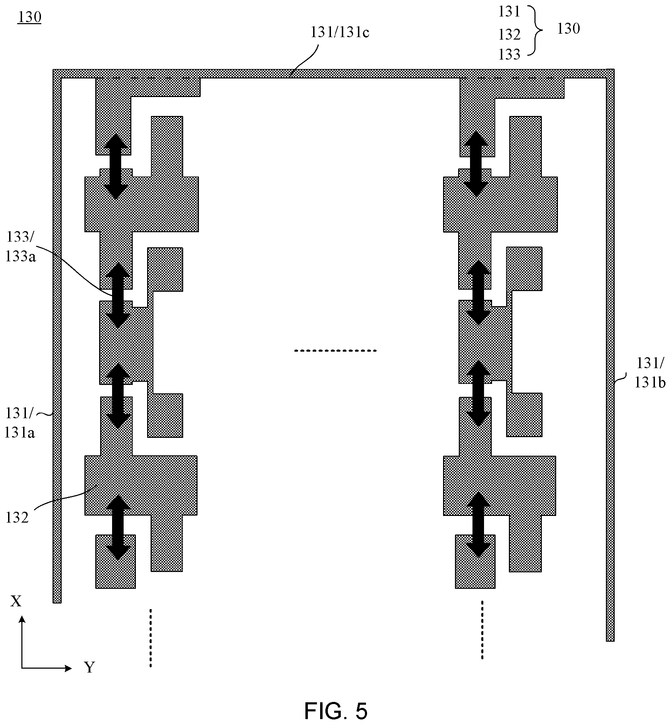

In some examples, as shown in FIG. 5, in the case where there are the plurality of first conductive patterns 132, in the first direction X, two adjacent first conductive patterns 132 are electrically connected, and a first conductive pattern 132 closest to the third sub-segment 131c is electrically connected to the third sub-segment 131c.

For example, two adjacent first conductive patterns 132 in a column of first conductive patterns 132 are electrically connected, and a first conductive pattern 132 in each column of first conductive patterns 132 along the first direction X is electrically connected to the third sub-segment 131c, so that each first conductive pattern 132 is directly or indirectly electrically connected to the third sub-segment 131c.

With the above arrangement, the static electricity in the functional area F may be conducted to the bonding area B through the first conductive patterns 132 in the first electrostatic pathway, thereby avoiding the influence of the static electricity accumulation on the function of the functional element group, improving the anti-static ability, and increasing the yield of manufacturing the light-emitting substrate.

For example, two adjacent first conductive patterns 132 in the second direction Y may also be electrically connected.

In some examples, the plurality of first conductive patterns 132 and the first annular conductive structure 131 are made of a same material and are arranged in a same layer.

For example, the first conductive patterns 132 may be made of a metal material, such as copper.

The above-mentioned "same layer" refers to a layer structure that is formed by forming a film layer for forming specific patterns using a same film forming process and then performing a single patterning process using a same mask. Depending on different specific patterns, the single patterning process may include multiple exposure, development or etching processes, and the specific patterns in the formed layer structure may be continuous or discontinuous, and these specific patterns may be at different heights or have different thicknesses.

With the above arrangement, the plurality of first conductive patterns 132 and the first annular conductive structure 131 are arranged in the same layer, and the first conductive patterns 132 are electrically connected to the third sub-segment 131c; and in this case, if there is no other structure between a first conductive pattern 132 and the third sub-segment 131c, the first conductive pattern 132 may be directly electrically connected to the third sub-segment 131c in the same layer without crossing other film layers, thereby simplifying the manufacturing process of the light-emitting substrate.

For example, the third sub-segment 131c and the first conductive pattern 132 electrically connected to the third sub-segment 131c form a one-piece structure.

The above-mentioned "one-piece structure" means that two connected patterns are arranged in a same layer, and the two patterns are continuous and not spaced apart. The above arrangement allows the third sub-segment 131c and the first conductive patterns 132 electrically connected thereto to be formed in a single patterning process, thereby simplifying the manufacturing process of the light-emitting substrate. In addition, the arrangement of the "one-piece structure" can improve the reliability of the electrical connection between the third sub-segment 131c and the first conductive patterns 132 without providing other conductive structures, thereby reducing the manufacturing cost of the light-emitting substrate.

In some examples, the first electrostatic pathway 130 further includes a plurality of bridge portions 133. In any column of first conductive patterns 132, two adjacent first conductive patterns 132 are electrically connected through a bridge portion 133.

It can be understood that the bridge portion 133 plays a conductive role. The bridge portion 133 is located in the functional area F.

For example, the bridge portion 133 is made of a conductive material. The bridge portion 133 may also be an electrical element, such as a resistor or a capacitor. The plurality of bridge portions 133 may all be made of the conductive material, or some of the bridge portions 133 are electrical elements, and some of the bridge portions 133 are made of the conductive material and only serve as electrical connections.

For example, the plurality of bridge portions 133 and the plurality of functional element groups 120 are located on the same side of the substrate 110, and the plurality of bridge portions 133 are located on a side of the first conductive patterns 132 away from the substrate 110.

In some examples, at least one of the plurality of bridge portions 133 is a jumper resistor 133a.

It can be understood that, the jumper resistor 133a is a special-purpose resistor, and the resistance value of the jumper resistor 133a is very small but is not completely zero. An automatic placement machine or automatic insertion machine may be used to arrange the jumper resistor 133a between two points in the light-emitting substrate 100 that cannot be directly connected through a line, so as to achieve electrical connection between the two points. Therefore, by making at least one of the plurality of bridge portions 133 be the jumper resistor 133a, the processing convenience of the light-emitting substrate 100 can be improved, and the cost of the light-emitting substrate 100 can be reduced.

For example, the plurality of bridge portions 133 may all be jumper resistors. Alternatively, some (one or more) of the plurality of bridge portions 133 are jumper resistors.

In some examples, as shown in FIG. 4, the light-emitting substrate 100 further includes a first connection line CL1 connecting the driver chip 121 and the light-emitting device group 122, and a second connection line CL2 connecting any two light-emitting devices 123 belonging to the same light-emitting device group 122.

For example, in a case where the light-emitting device group 122 includes two light-emitting devices 123, there is one second connection line CL2 in the same light-emitting device group 122.

For another example, in a case where the light-emitting device group 122 includes six light-emitting devices 123, there are five second connection lines CL2 in the same light-emitting device group 122.

It can be understood that the arrangement of the second connection line(s) CL2 are related to the arrangement of the light-emitting devices 123 in the light-emitting device group 122. For example, in the case where the light-emitting device group 122 includes six light-emitting devices 123, the six light-emitting devices 123 are connected in series, and the six light-emitting devices 123 are arranged in two rows along the first direction X and are arranged in three columns along the second direction Y; two adjacent second connection lines CL2 extend along the first direction X and the second direction Y, respectively; and a contour of an orthographic projection of the light-emitting device group 122 and the plurality of second connection lines CL2 on the substrate is concave-convex.

For example, orthographic projections of the plurality of first conductive patterns 132 on the substrate 110 do not overlap with orthographic projections of the first connection line CL1 and the second connection line CL2 on the substrate 110. That is, the plurality of first conductive patterns 132 do not cover the first connection line CL1 and the second connection line CL2, and the first connection line CL1 and the second connection line CL2 do not cover the plurality of first conductive patterns 132.

For example, there is no overlapping between the orthographic projections of the plurality of first conductive patterns 132 on the substrate 110 and the orthographic projections of the first connection line CL1 and the second connection line CL2 on the substrate 110.

For example, a shape of an orthographic projection of a first conductive pattern 132 on the substrate 110 is the same as a shape of a region enclosed by two light-emitting device groups 122 that are adjacent to the first conductive pattern 132 along the first direction X.

For example, a first conductive pattern 132 may be located between two light-emitting device groups 122 that are adjacent to the first conductive pattern 132 along the first direction X. A first conductive pattern 132 may also be located between two functional element groups 120 that are adjacent to the first conductive pattern 132 along the first direction X. A first conductive pattern 132 may also be located between a functional element group 120 closest to the third sub-segment 131c and the third sub-segment 131c.

For example, an area of the orthographic projection of the first conductive pattern 132 on the substrate 110 may be less than an area of the region enclosed by the two light-emitting device groups 122 that are adjacent to the first conductive pattern 132 along the first direction X.

For example, the first conductive pattern 132 may almost fill the region enclosed by the two light-emitting device groups 122 that are adjacent to the first conductive pattern 132 along the first direction X. Alternatively, the first conductive pattern 132 may fill a part of the region enclosed by the two light-emitting device groups 122 that are adjacent to the first conductive pattern 132 along the first direction X.

In some examples, the plurality of first conductive patterns 132, the first connection line CL1 and the second connection line CL2 are made of the same material and are arranged in the same layer.

For example, the first connection line CL1 may be made of a metal material, such as copper.

With the above arrangement, the first conductive patterns 132, the first connection line CL1 and the second connection line CL2 may be formed in a single patterning process, thereby simplifying the manufacturing process of the light-emitting substrate 100.

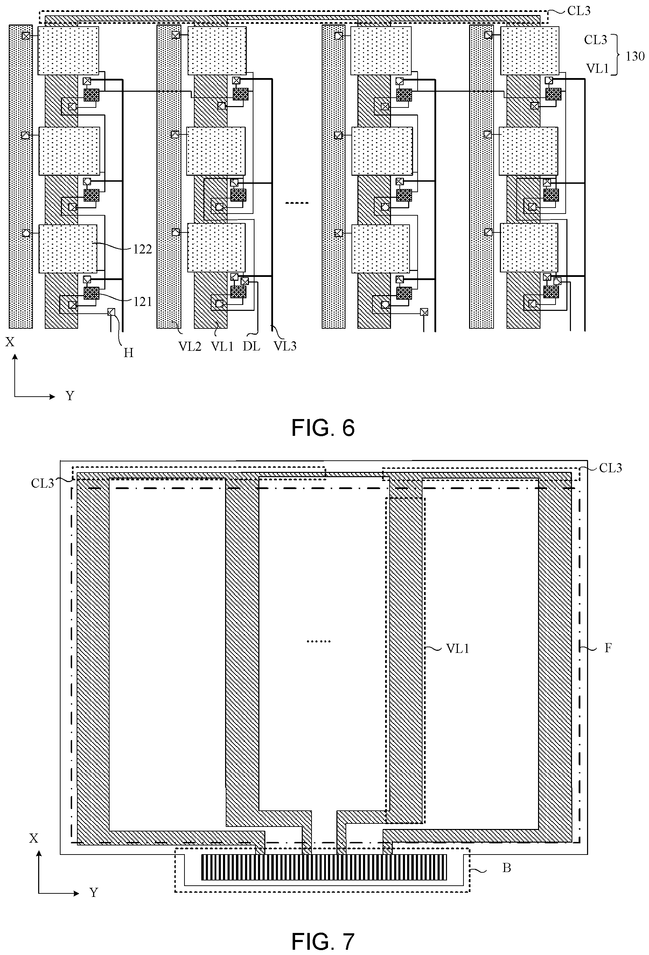

In some other embodiments, as shown in FIG. 6, the first electrostatic pathway 130 includes a plurality of first voltage lines VL1 and at least one third connection line CL3. The plurality of first voltage lines VL1 extend along the first direction X, and are arranged at intervals along the second direction Y. A third connection line CL3 is used to connect at least two first voltage lines VL1.

It can be understood that H in FIG. 6 represents a via hole. For example, a pin of the driver chip 121 passes through a via hole to be electrically connected to a signal line (e.g., a first voltage line VL1, or a data line DL), or a pin of the light-emitting device group 122 passes through a via hole to be electrically connected to a second voltage signal line VL2.

In some examples, multiple functional element groups 120 arranged along the first direction X are connected to one first voltage line VL1.

For example, the first voltage lines VL1 are located in the functional area F, a first voltage line VL1 is electrically connected to a column of functional element groups 120, and the first voltage line VL1 extends to the bonding area B and is electrically connected to the bonding area B (e.g., a first voltage signal pin group mentioned below), so that a signal from the display chip can be transmitted to the functional element groups 120.

For example, a first voltage signal transmitted by the first voltage signal line VL1 may be a constant voltage signal. The first voltage signal line VL1 can be electrically connected to the driver chip 121, and provide the first voltage signal for a plurality of light-emitting devices 123 in light-emitting device group(s) 122 of a corresponding same functional element group 120 through the driver chip 121. The first voltage signal may be a ground voltage signal for the functional element group 120.

For example, the first electrostatic pathway 130 may include one third connection line CL3.

For another example, the first electrostatic pathway 130 may include a plurality of third connection lines CL3, and multiple adjacent third connection lines CL3 may not be connected to each other.

In yet another example, the first electrostatic pathway 130 may include a plurality of third connection lines CL3, and multiple adjacent third connection lines CL3 may be connected to each other.

For example, a third connection line CL3 may be used to connect two first voltage lines VL1.

For another example, a third connection line CL3 may be used to connect multiple first voltage lines VL1.

With the above arrangement, in the case that there is the static electricity accumulation between two adjacent columns of functional element groups 120, the static electricity may be conducted to the bonding area B through the first voltage lines VL1 and the third connection line(s) CL3, thereby preventing the static electricity from being transmitted between the two adjacent columns of functional element groups 120. Thus, it avoids the transmission of the static electricity from the first voltage signal line VL1 to the light-emitting device 123, avoids the transmission of the static electricity from the light-emitting device 123 to the driver chip 121 along the first connection line CL1, and avoids affecting the accuracy of the signal transmitted from the driver chip 121 to the light-emitting device 123. As a result, poor lighting of the light-emitting device is avoided, thereby improving the anti-static ability of the light-emitting substrate, especially avoiding charging and discharging phenomenon of CDM.

In some examples, as shown in FIG. 7, the third connection line CL3 is located on the side of the functional area F away from the bonding area B. As a result, the anti-static ability of a position of the functional area F away from the bonding area B (i.e., the sky side of the light-emitting substrate) may be greatly enhanced, thereby avoiding functional damage to the functional element groups 120 close to the sky side.

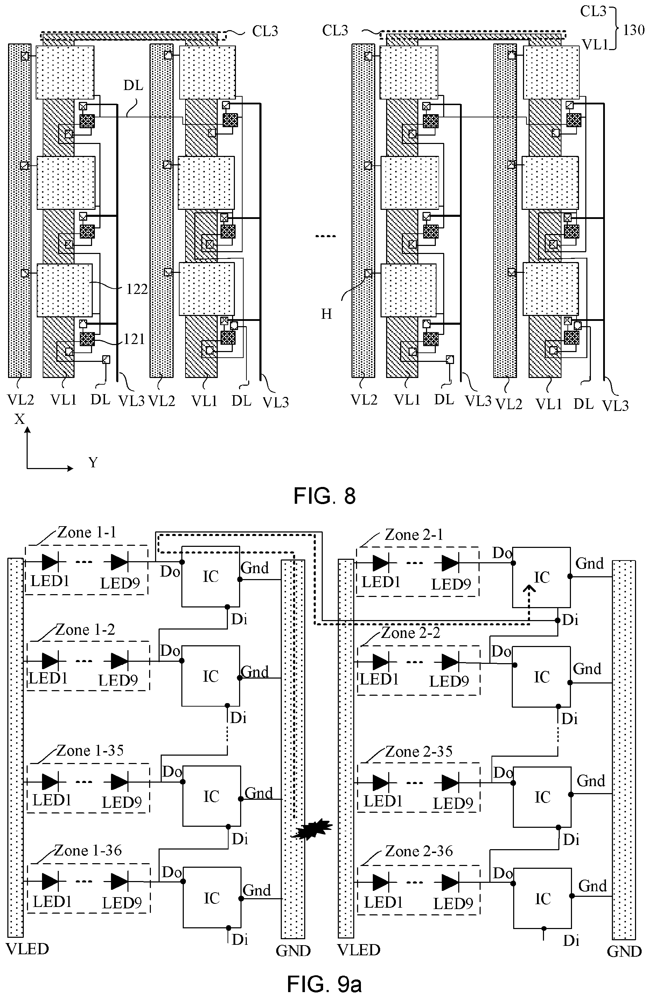

For example, as shown in FIG. 8, the light-emitting substrate 100 further includes a plurality of addressing signal lines DL.

For example, addressing signal lines DL connect two driver chips 121 of two functional element groups 120 that are adjacent along the first direction X. Along the second direction Y, a functional element group closest to the sky side in the (2i-1)-th column of functional element groups 120 and a functional element group closest to the sky side in the 2i-th column of functional element groups 120 are connected through an addressing signal line DL.

In some examples, as shown in FIG. 8, along the second direction Y, the (2i-1)-th first voltage line VL1 and the 2i-th first voltage line VL1 are connected to a same third connection line CL3; and i is a positive integer.

With the above arrangement, in the case that static electricity is generated in the light-emitting substrate, the static electricity may be transmitted along the (2i-1)-th first voltage line VL1, the 2i-th first voltage line VL1 and the corresponding third connection line CL3, thereby improving the anti-static ability and the yield of the light-emitting substrate. Thus, it may be possible to prevent the static electricity from being transmitted along the (2i-1)-th functional element group 120, the corresponding addressing signal lines DL and the 2i-th functional element group 120 to the driver chips 121 in the functional element groups 120, thereby preventing the static electricity from being greater than 12 kV, preventing the static electricity from damaging the driver chips 121, and avoiding the poor lighting of light-emitting device groups 122 controlled by the driver chips 121.

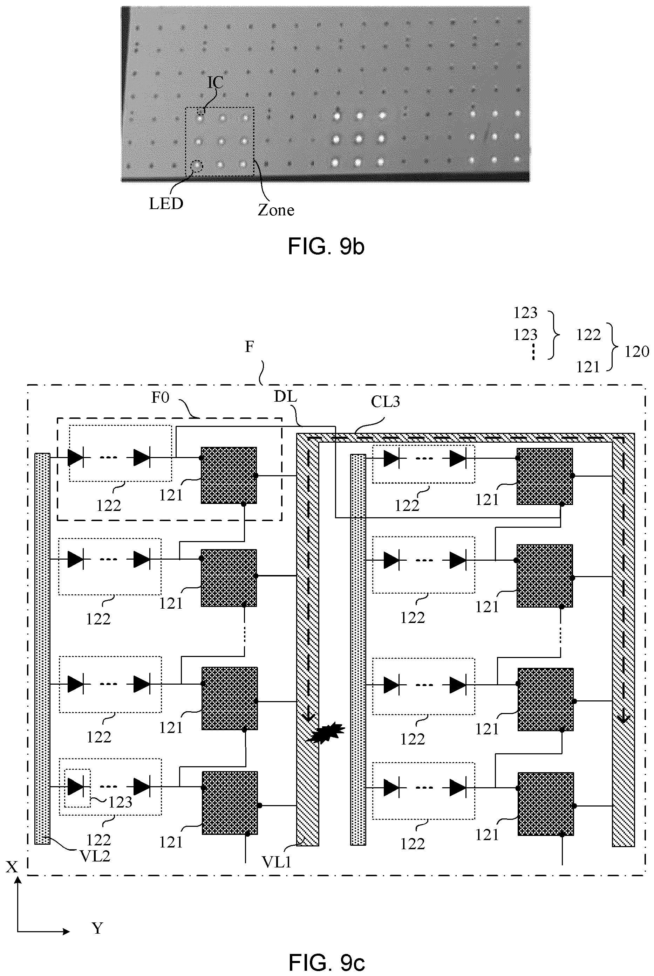

It can be understood that FIG. 9a shows the transmission of the static electricity in the light-emitting substrate in one implementation. The path shown by the dotted line with an arrow in FIG. 9a is the transmission path of the static electricity. During the manufacturing process of the light-emitting substrate, static electricity is conducted to the light-emitting substrate and transmitted along the GND line. Since GND lines of odd-numbered columns and GND lines of even-numbered columns are connected to the driver chips through the addressing signal lines, the static electricity will be transmitted to the driver chips through the addressing signal lines. When the static electricity is greater than 12 kV, the driver chip is damaged, and pins (Do and Di in the figure) of the driver chip IC for connecting the addressing signal lines are broken down and leak to the ground, resulting in the poor lighting of light-emitting devices (LED1 to LED9 in the figure) in the lamp zone Zone 2-1 controlled by the driver chip IC. The specific poor lighting situation may be made reference to an actual product diagram of FIG. 9b. In FIG. 9b, regions enclosed by three dotted squares are three lamp zones with the poor lighting.

In the embodiments of the present disclosure, along the second direction Y, the (2i-1)-th first voltage line VL1 and the 2i-th first voltage line VL1 are connected to the same third connection line CL3, so that the transmission path of the static electricity in the light-emitting substrate changes (as shown in FIG. 9c), and the static electricity is transmitted on the first voltage lines VL1 of the first electrostatic pathway 130. It may be possible to improve the anti-static ability of the light-emitting substrate, prevent the static electricity from being transmitted to the driver chips 121, prevent the pins of the driver chips 121 from being broken down, and avoid the poor lighting of the light-emitting substrate.

In some examples, as shown in FIG. 7, in a case where there are a plurality of third connection lines CL3, the plurality of third connection lines CL3 are connected to form a one-piece structure.

For example, the above arrangement can be that two adjacent third connection lines CL3 are connected to form a one-piece structure. The above arrangement can also be that multiple adjacent third connection lines CL3 are connected to form a one-piece structure.

With the above arrangement, the plurality of third connection lines CL3 may be formed in a single patterning process, thereby simplifying the manufacturing process of the light-emitting substrate 100.

In some examples, the plurality of first voltage lines VL1 and the plurality of third connection lines CL3 are made of a same material and arranged in a same layer.

For example, the material of the third connection lines CL3 may be metal, such as copper.

The above-mentioned "same layer" refers to a layer structure that is formed by forming a film layer for forming specific patterns using a same film forming process and then performing a single patterning process using a same mask. Depending on different specific patterns, the single patterning process may include multiple exposure, development or etching processes, and the specific patterns in the formed layer structure may be continuous or discontinuous, and these specific patterns may be at different heights or have different thicknesses.

With the above arrangement, in the case where the first voltage line VL1 and the third connection line CL3 are electrically connected and there is no other structure between the first voltage line VL1 and the third connection line CL3, the first voltage line VL1 may be directly electrically connected to the third connection line CL3 in the same layer without crossing other film layers, thereby simplifying the manufacturing process of the light-emitting substrate.

For example, the third connection line CL3 and the first voltage line VL1 electrically connected thereto are of a one-piece structure. Thus, the third connection line CL3 and the first voltage line VL1 electrically connected thereto may be formed in a single patterning process, thereby simplifying the manufacturing process of the light-emitting substrate. In addition, the arrangement of the "one-piece structure" can improve the reliability of the electrical connection between the third connection line CL3 and the first voltage line VL1 without providing other conductive structures, thereby reducing the manufacturing cost of the light-emitting substrate.

In some examples, as shown in FIG. 9c, the plurality of functional element groups 120 are arranged in multiple columns. The functional area F includes a plurality of device regions F0, and a single functional element group 120 is located in one device region F0.

For example, the plurality of device regions F0 are arranged in an array.

For example, the first electrostatic pathway 130 includes a plurality of second voltage lines VL2. A single second voltage line VL2 is electrically connected to one column of functional element groups 120.

For example, the second voltage line VL2 extends along the first direction X.

For example, the second voltage line VL2 is electrically connected to an end of a light-emitting device group 122 in the column of functional element groups 120. The second voltage line VL2 is further electrically connected to the bonding area B, and the second voltage signal line VL2 is used to provide a second voltage signal to the light-emitting device group 122. The second voltage signal may be a device power supply voltage signal for the light-emitting device group 122.

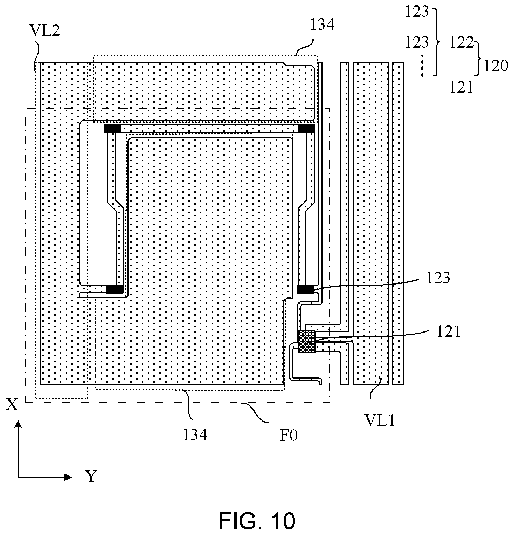

For example, as shown in FIG. 10, the first electrostatic pathway 130 further includes a plurality of second conductive patterns 134. Orthographic projections of the plurality of second conductive patterns 134 on the substrate 110 do not overlap with orthographic projections of the functional element groups 120 on the substrate 110.

For example, there is no overlapping between the orthographic projections of the plurality of second conductive patterns 134 on the substrate 110 and the orthographic projections of the functional element groups 120 on the substrate 110. That is, the plurality of second conductive patterns 134 and the plurality of functional element groups 120 do not cover each other.

It can be understood that the orthographic projections of the plurality of second conductive patterns 134 on the substrate 110 do not overlap with the orthographic projections of the first connection lines CL1 and the second connection lines CL2 in the plurality of functional element groups 120 on the substrate 110. The plurality of second conductive patterns 134 do not cover or block the first connection lines CL1 and the second connection lines CL2, and the first connection lines CL1 and the second connection lines CL2 do not cover or block the plurality of second conductive patterns 134.

For example, a shape of an orthographic projection of a second conductive pattern 134 on the substrate 110 is the same as a shape of a region enclosed by two light-emitting device groups 122 that are adjacent to the second conductive pattern 134 along the first direction X.

For example, an area of the orthographic projection of the second conductive pattern 134 on the substrate 110 may be less than that of the region enclosed by the two light-emitting device groups 122 that are adjacent to the second conductive pattern 134 along the first direction X.

For example, the second conductive pattern 134 may fill the region enclosed by the two light-emitting device groups 122 that are adjacent to the second conductive pattern 134 along the first direction X. Alternatively, the second conductive pattern 134 may fill a part of the region enclosed by the two light-emitting device groups 122 that are adjacent to the second conductive pattern 134 along the first direction X.

For example, the second conductive pattern 134 is electrically connected to a second voltage line VL2, and at least a portion of the second conductive pattern 134 is located in a device region F0.

For example, a portion of the second conductive pattern 134 may be located in a device region F0, and another portion of the second conductive pattern 134 may be located in another device region F0 adjacent to the device region F0. The second conductive pattern 134 may be located between two functional element groups 120 adjacent along the first direction X.

For another example, the entire second conductive pattern 134 is located in a device region F0. The second conductive pattern 134 may be located between two light-emitting device groups 122 adjacent along the first direction X.

In yet another example, a portion of the second conductive pattern 134 is located in a device region F0, and another portion of the second conductive pattern 134 is located in an area between a functional element group 120 closest to the third sub-segment 131c and the third sub-segment 131c.

Of course, the second conductive pattern 134 may also be located in an area between two adjacent device regions F0.

With the above arrangement, the static electricity generated during the manufacturing process of the light-emitting substrate may be conducted to the second voltage line VL2 through the second conductive pattern 134, and then conducted to the bonding area B through the second voltage line VL2, so that the static electricity is transmitted from the functional area F to the bonding area B. As a result, the anti-static ability of the light-emitting substrate is improved, and the static electricity is prevented from accumulating in the functional area F, thereby preventing the static electricity from breaking down the pads of the functional element groups 120 in the functional area F, and avoiding the poor lighting.

For example, the plurality of second conductive patterns 134 may be arranged in multiple rows and multiple columns. A single second voltage line VL2 may be electrically connected to second conductive patterns 134 in one column of second conductive patterns 134.

For example, the plurality of second voltage lines VL2 and the plurality of second conductive patterns 134 are made of a same material and arranged in a same layer.

For example, a material of the second conductive patterns 134 may be metal, such as copper.

The above-mentioned "same layer" refers to a layer structure that is formed by forming a film layer for forming specific patterns using a same film forming process and then performing a single patterning process using a same mask. Depending on different specific patterns, the single patterning process may include multiple exposure, development or etching processes, and the specific patterns in the formed layer structure may be continuous or discontinuous, and these specific patterns may be at different heights or have different thicknesses.

With the above arrangement, in a case where the second voltage line VL2 and the second conductive patterns 134 are electrically connected and there is no other structure between the second voltage line VL2 and the second conductive patterns 134, the second voltage line VL2 may be directly electrically connected to the second conductive patterns 134 in the same layer without crossing other film layers, thereby simplifying the manufacturing process of the light-emitting substrate.

For example, the second voltage line VL2 and the second conductive patterns 134 electrically connected thereto form a one-piece structure. As a result, the second voltage line VL2 and the second conductive patterns 134 electrically connected thereto may be formed in a single patterning process, thereby simplifying the manufacturing process of the light-emitting substrate. In addition, the arrangement of the "one-piece structure" may improve the reliability of the electrical connection between the second voltage line VL2 and the second conductive patterns 134 without providing other conductive structures, thereby reducing the manufacturing cost of the light-emitting substrate.

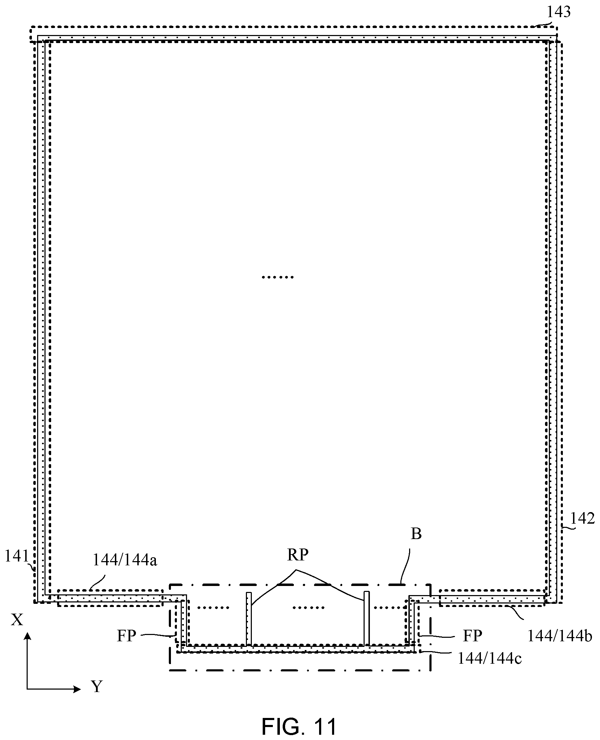

In some examples, as shown in FIG. 11, the light-emitting substrate 100 further includes a plurality of functional pins FP located in the bonding area B and a second electrostatic pathway 140.

For example, the second electrostatic pathway 140 is a second annular conductive structure surrounding the functional area F. The second annular conductive structure includes a first sub-portion 141, a second sub-portion 142, a third sub-portion 143 and a fourth sub-portion 144 that are electrically connected in sequence. The first sub-portion 141 and the second sub-portion 142 are located on opposite sides of the functional area F along the second direction Y, the third sub-portion 143 is located on the side of the functional area F away from the bonding area B, and a portion of the fourth sub-portion 144 is located on a side of the bonding area B away from the functional area F.

For example, the fourth sub-portion 144 includes a first part 144a, a second part 144b, and a third part 144c. The first part 144a of the fourth sub-portion 144 is electrically connected to the third sub-portion 143, the third part 144c of the fourth sub-portion 144 is electrically connected to the first sub-portion 141, and the third part 144c of the fourth sub-portion 144 is located on the side of the bonding area B away from the functional area F. The first part 144a, the second part 144b and the third part 144c all extend along the second direction Y, and along the second direction Y, the first part 144a, the third part 144c and the second part 144b are arranged in sequence and are not connected.

For example, the plurality of functional pins FP are electrically connected to the portion of the fourth sub-portion 144 located on the side of the bonding area B away from the functional area F.

For example, functional pins FP are electrically connected to the third part 144c and the first part 144a of the fourth sub-portion 144, and functional pins FB are electrically connected to the third part 144c and the second part 144b of the fourth sub-portion 144, thereby achieving the electrical connections among the first part 144a, the third part 144c, and the second part 144b of the fourth sub-portion 144, and making the second electrostatic pathway 140 have a closed ring shape.

For example, the second electrostatic pathway 140 is configured to conduct static electricity from the functional area F to the bonding area B.

With the above arrangement, the second electrostatic pathway 140 is disposed in the light-emitting substrate 100, and the second electrostatic pathway 140 is the annular conductive structure, so that the static electricity generated in the functional area F of the light-emitting substrate 100 may be conducted to the bonding area B through the second electrostatic pathway 140. Thus, it may be possible to prevent the static electricity from accumulating in the functional area F, prevent the static electricity from breaking down the pads of the functional element groups 120 in the functional area F, and avoid the poor lighting. In addition, due to the arrangement of the fourth sub-portion 144, in a case where the light-emitting substrate 100 is not bonded to the display chip, the fourth sub-portion 144, the first sub-portion 141, the second sub-portion 142 and the third sub-portion 143 form a closed loop through the functional pins FP, thereby conducting the static electricity generated during the manufacturing process of the light-emitting substrate to the closed loop, increasing the yield of the light-emitting substrate, and avoiding damages to the driver chips caused by the static electricity.

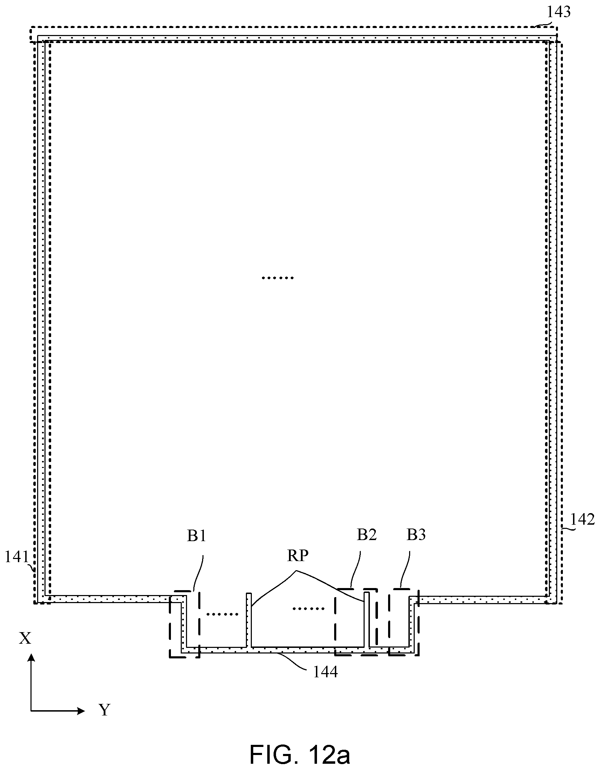

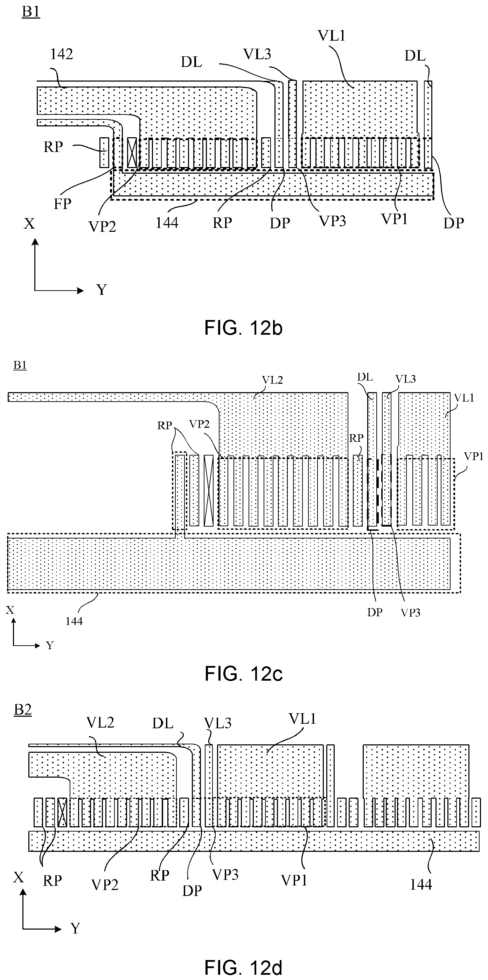

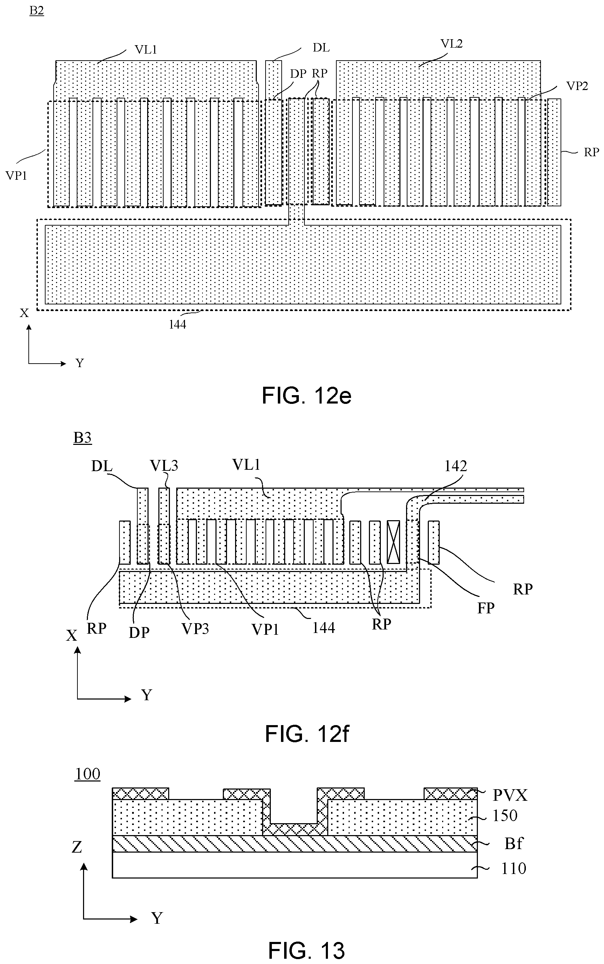

In some examples, as shown in FIG. 12a, the light-emitting substrate 100 further includes a plurality of dummy pins RP located in the bonding area B.

For example, at least one dummy pin RP is electrically connected to the portion of the fourth sub-portion 144 located on the side of the bonding area B away from the functional area F.

For example, one dummy pin RP is electrically connected to the portion of the fourth sub-portion 144 located on the side of the bonding area B away from the functional area F.

For another example, multiple dummy pins RP are electrically connected to the portion of the fourth sub-portion 144 located on the side of the bonding area B away from the functional area F.

With the above arrangement, the static electricity in the light-emitting substrate 100 may be conducted to the second electrostatic pathway 140 through the dummy pins RP, thereby increasing conducting paths for the static electricity in the functional area F, and improving the anti-static ability of the light-emitting substrate.

In some examples, as shown in FIGS. 12b to 12f, the light-emitting substrate 100 further includes a plurality of first voltage signal pin groups VP1 and a plurality of second voltage signal pin groups VP2 located in the bonding area B. A second voltage signal pin group VP2 includes a plurality of second voltage signal pins, and a first voltage signal pin group VP1 includes a plurality of first voltage signal pins.

For example, the plurality of first voltage signal pins in the first voltage signal pin group VP1 are arranged at intervals, and the plurality of first voltage signal pins are arranged in a row. The plurality of second voltage signal pins in the second voltage signal pin group VP2 are arranged at intervals, and the plurality of second voltage signal pins are arranged in a row. The plurality of first voltage signal pin groups VP1 and the plurality of second voltage signal pin groups VP2 are arranged in a row.

For example, the first voltage signal pins may be electrically connected to at least one first voltage line VL1, and the second voltage signal pins may be electrically connected to at least one second voltage line VL2.

It can be understood that, during the process of bonding the light-emitting substrate to the display chip, the first voltage signal pins can be electrically connected to the display chip, so that a first voltage signal transmitted by the display chip can be received by the first voltage signal pins and the first voltage signal can be transmitted to the corresponding first voltage line(s) VL1; and the second voltage signal pins can be electrically connected to the display chip, so that a second voltage signal transmitted by the display chip can be received by the second voltage signal pins, and the second voltage signal can be transmitted to the corresponding second voltage line(s) VL2.

For example, the plurality of first voltage signal pin groups VP1 and the plurality of second voltage signal pin groups VP2 are alternately arranged along the second direction Y, and at least one dummy pin RP is disposed between any adjacent first voltage signal pin group VP1 and second voltage signal pin group VP2.

For example, at least one dummy pin RP is disposed between adjacent second voltage signal pin group VP2 and first voltage signal pin group VP1. Alternatively, at least one dummy pin RP is disposed between adjacent first voltage signal pin group VP1 and second voltage signal pin group VP2.

For example, one dummy pin RP is disposed between the second voltage signal pin group VP2 and first voltage signal pin group VP1.

For another example, multiple dummy pins RP are disposed between the second voltage signal pin group VP2 and first voltage signal pin group VP1.

With the above arrangement, the static electricity in the light-emitting substrate may be conducted to the dummy pin RP, so that the static electricity may be conducted to the second electrostatic pathway 140 through the dummy pin RP, thereby enabling the static electricity to be conducted out and improving the anti-static ability of the light-emitting substrate 100. Furthermore, the static electricity in the light-emitting substrate is prevented from being conducted to the adjacent second voltage signal pin group VP2 and first voltage signal pin group VP1, thereby preventing the static electricity from accumulating on the adjacent second voltage signal pin group VP2 and first voltage signal pin group VP1, preventing the static electricity from breaking down the adjacent second voltage signal pin and the first voltage signal pin, and avoiding the poor lighting of the light-emitting substrate 100.

It can be understood that, as shown in FIG. 12d, a dummy pin RP that is not electrically connected to the fourth sub-portion 144 can be used to prevent signal interference between the second voltage signal pin group VP2 and an addressing pin DP that are respectively located on the left side and right side of the dummy pin RP, thereby improving the accuracy of the second voltage signal transmitted by the second voltage signal pin group VP2 and the accuracy of the address signal transmitted by the addressing pin DP, and improving the performance of the light-emitting substrate.

For example, as shown in FIG. 12b, a dummy pin RP may be located on a side of the functional pin FP away from the second voltage pin group VP2, or may be located between the second voltage pin group VP2 and the data pin DP.

In some examples, in the second direction Y, a size of a distance between the dummy pin RP electrically connected to the fourth sub-portion 144 and the second voltage signal pins of the second voltage signal pin group VP2 adjacent to the dummy pin RP is greater than or equal to 200 µm.

For example, in the second direction Y, the size of the distance between the dummy pin RP electrically connected to the fourth sub-portion 144 and the second voltage signal pins of the second voltage signal pin group VP2 adjacent to the dummy pin RP may be 200 µm.

For another example, in the second direction Y, the size of the distance between the dummy pin RP electrically connected to the fourth sub-portion 144 and the second voltage signal pins of the second voltage signal pin group VP2 adjacent to the dummy pin RP may be 210 µm, 220 µm, 230 µm, 240 µm, or 250 µm.

With the above arrangement, the accuracy of the second voltage signal transmitted by the second voltage signal pins may be improved, which achieves the accurate control of the light-emitting devices in the functional element group by the display chip, the distance between the dummy pin RP and the adjacent second voltage signal pin is avoided too small, and the static electricity on the dummy pin RP is prevented from interfering or affecting the second voltage signal transmitted by the adjacent second voltage signal pin. Thus, it avoids the influence on the light-emitting devices 123 in the functional element group 120.

In some examples, a distance between two adjacent first voltage signal pins is greater than or equal to 100 µm.

For example, the distance between two adjacent first voltage signal pins is 100 µm, 105 µm, 110 µm, 112 µm, or 115 µm.

With the above arrangement, the distance between two adjacent first voltage signal pins may be relatively large, which improves the accuracy of the first voltage signal transmitted by the first voltage signal pin, achieves the accurate control of the light-emitting devices in the functional element group by the display chip, avoids the distance between adjacent first voltage signal pins from being too small, avoids affecting the bonding effect between the first voltage signal pins and the display chip, and thereby avoids short circuit between the first voltage signal pins and the display chip.

In some examples, the second electrostatic pathway 140, the plurality of functional pins FP, the plurality of dummy pins RP, the plurality of second voltage signal pin groups VP2 and the plurality of first voltage signal pin groups VP1 are made of a same material and arranged in a same layer.

For example, the material of the functional pins FP may be metal, such as copper.

With the above arrangement, the second electrostatic pathway 140, the plurality of functional pins FP, the plurality of dummy pins RP, the plurality of second voltage signal pin groups VP2 and the plurality of first voltage signal pin groups VP1 may be formed in a single patterning process, thereby simplifying the manufacturing process of the light-emitting substrate.

For example, the second electrostatic pathway 140 and the plurality of functional pins FP and dummy pins RP electrically connected the second electrostatic pathway 140 form a one-piece structure.

The above-mentioned "one-piece structure" means that two connected patterns are arranged in a same layer, and the two patterns are continuous and not spaced apart. The above arrangement allows the second electrostatic pathway 140 and the plurality of functional pins FP and the dummy pins RP electrically connected the second electrostatic pathway 140 to be formed in a single patterning process, thereby simplifying the manufacturing process of the light-emitting substrate. In addition, the arrangement of the "one-piece structure", can improve the reliability of the electrical connections of the second electrostatic pathway 140 to the plurality of functional pins FP and the dummy pins RP without providing other conductive structures, thereby reducing the manufacturing cost of the light-emitting substrate.

It can be understood that, firstly, as shown in FIG. 4, the light-emitting substrate 100 further includes a plurality of third voltage lines VL3 and a plurality of data lines SL. The third voltage lines VL3 extend along the first direction X, and the third voltage lines VL3 are arranged at intervals along the second direction Y. A third voltage line VL3 is electrically connected to driver chips 121 in a column of functional element groups 120. The data lines SL extend along the first direction X, and the data lines SL are arranged at intervals along the second direction Y. A data line SL is electrically connected to driver chips 121 in a column of functional element groups 120, and the data line SL transmits a data signal to corresponding driver chips 121.

For example, as shown in FIG. 12b, the light-emitting substrate 100 further includes a plurality of addressing pins DP and a plurality of third voltage signal pins VP3 located in the bonding area B.

For example, the third voltage line VL3 is electrically connected to the third voltage signal pin VP3 in the bonding area B. The third voltage signal pin VP3 is used to receive a third voltage signal from the display chip, and transmit the third voltage signal to the third voltage line VL3 and the driver chip 121 in sequence. The third voltage signal may be a constant voltage signal. For example, the third voltage signal may be a device power supply voltage signal for the driver chip 121.

For example, the addressing signal line DL is electrically connected to the addressing pin DP in the bonding area B. The addressing pin DP is used to receive an address signal from the display chip, and transmit the address signal to the addressing signal line DL and the driver chip 121 in sequence.

For example, there are various relative positional relationships for the third voltage signal pins VP3, the third voltage signal pins VP3, the plurality of functional pins FP, the plurality of dummy pins RP, the plurality of second voltage signal pin groups VP2 and the plurality of first voltage signal pin groups VP1 that are located in the bonding area B, which can be set according to actual situations, and the present application does not limit this.

For example, the third voltage signal pins VP3, the third voltage signal pins VP3, the plurality of functional pins FP, the plurality of dummy pins RP, the plurality of second voltage signal pin groups VP2 and the plurality of first voltage signal pin groups VP1 are arranged in a row along the second direction Y. As shown in FIG. 12d, various pins are cyclically arranged from left to right in accordance with a sequence of: at least one dummy pin RP, a functional pin FP, a second voltage signal pin group VP2, at least one dummy pin RP, an addressing pin DP, and a first voltage signal pin group VP1.

In some embodiments, as shown in FIG. 13, the light-emitting substrate 100 includes a first conductive layer 150 located on a side of the substrate 110. A material of the first conductive layer 150 may include metal, such as copper.

For example, there are a plurality of first pad patterns in the first conductive layer 150, and at least two adjacent first pad patterns constitute a first pad group.

It can be understood that, the driver chip 121 includes at least two pins, and the light-emitting device 123 includes two pins. The pins of the driver chip 121 are soldered to the first pad patterns of the first pad group, so as to fix the driver chip 121. The pins of the light-emitting device 123 may also be soldered to the first pad patterns of the first pad group, so as to fix the light-emitting device 123.

For example, in the light-emitting substrate, the first voltage lines VL1, the second voltage lines VL2, the third voltage lines VL3, the addressing lines DL, the first connection lines CL1, the second connection lines CL2, and the first annular conductive structure 131 and the first conductive pattern(s) 132 of the first electrostatic pathway 130 are all located in the first conductive layer 150.

For another example, in the light-emitting substrate, the second voltage lines VL2, the third voltage lines VL3, the addressing lines DL, the first connection lines CL1, the second connection lines CL2, and the first voltage lines VL1 and the third connection line(s) CL3 of the first electrostatic pathway 130 are all located in the first conductive layer 150.

In yet another example, in the light-emitting substrate, the first voltage lines VL1, the third voltage lines VL3, the addressing lines DL, the first connection lines CL1, the second connection lines CL2, the second voltage lines VL2 and the first conductive pattern(s) 132 of the first electrostatic pathway 130 are all located in the first conductive layer 150.

In yet another example, in the light-emitting substrate, the first voltage lines VL1, the second voltage lines VL2, the third voltage lines VL3, the addressing lines DL, the first connection lines CL1, the second connection lines CL2, the third voltage signal pins VP3, the third voltage signal pins VP3, the functional pins FP, the dummy pins RP, the second voltage signal pin groups VP2, the first voltage signal pin groups VP1 and the annular conductive structure of the second electrostatic pathway 140 are all located in the first conductive layer 150.

With the above arrangement, the anti-static ability of the light-emitting substrate 100 may be improved, and the charging and discharging phenomenon of CDM that occurs during the manufacturing process of the light-emitting substrate may be avoided.

For example, the first conductive layer 150 includes various patterns, the patterns include the first pad patterns, patterns for forming various signal lines (the signal lines include the first voltage lines VL1, the second voltage lines VL2, the third voltage lines VL3, the addressing lines DL, the first connection lines CL1, and the second connection lines CL2), and the patterns for forming the first electrostatic pathway 130.

For example, the manufacturing method of the first conductive layer 150 may include: forming a first conductive film 151 on a side of the substrate; placing a mask on a side of the first conductive film 151 away from the substrate; and etching the first conductive film 151 by using a wet etching process to form the first conductive layer 150 including the various patterns. The wet etching process includes etching the first conductive film 151 by using etching solution.

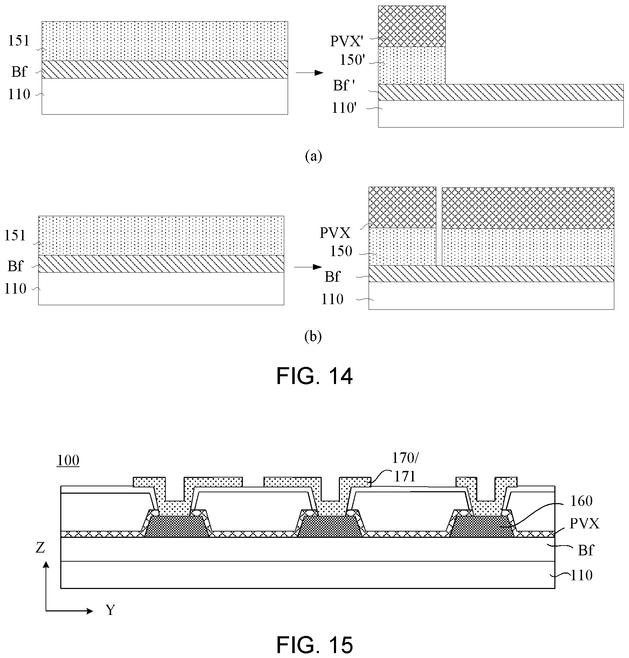

In some embodiments of the present disclosure, the arrangement of the first electrostatic pathway 130 enables the pattern proportion of the first conductive layer 150 (the pattern proportion here refers to the proportion of the total area of the various patterns of the first conductive pattern 150 to the area of the first conductive film 151) to be greatly increased, thereby greatly reducing the amount of etching solution used and the manufacturing cost of the light-emitting substrate. (a) in FIG. 14 is a schematic diagram showing the pattern proportion in a first conductive layer 150' after the first conductive layer 150' is formed by a first conductive film 151 in an implementation. (b) in FIG. 14 is a schematic diagram showing the pattern proportion in a first conductive layer 150 after the first conductive layer 150 is formed by a first conductive film 151, in accordance with to some embodiments of the present application. It can be seen that in the embodiments of the present disclosure, the pattern proportion of the first conductive layer 150 is greatly increased, and the pattern proportion of the first conductive layer 150 is increased about from 20% to 80%, thereby greatly reducing the amount of etching solution used and the manufacturing cost of the light-emitting substrate.

In addition, in some embodiments of the present disclosure, the arrangement of the first electrostatic pathway enables the pattern proportion of the first conductive layer 150 to be increased, which makes the contact area between the first conductive layer 150 and other film layers (such as a passivation layer PVX or a buffer layer Bf mentioned below) be relatively large. Thus, more heat on the first conductive layer 150 may be transferred or diffused to other film layers, and the overall heat dissipation ability of the light-emitting substrate 100 may be improved, which may prevent the temperature of the various patterns in the first conductive layer from being too high, and avoid affecting the stability of signal transmission and the functions of the light-emitting substrate 100.

As shown in FIG. 13, the light-emitting substrate 100 further includes a buffer layer Bf located between the first conductive layer 150 and the substrate 110, and a passivation layer PVX located on a side of the first conductive layer 150 away from the substrate 110.

For example, the buffer layer Bf may be made of an inorganic material, such as silicon nitride or silicon dioxide. The buffer layer B can protect the substrate 110, so that the substrate 110 is not easily broken when subjected to the stress generated by the first conductive layer 150.

For example, the passivation layer PVX may be made of an inorganic material, such as silicon nitride or silicon dioxide.

Secondly, in some other embodiments, as shown in FIG. 15, the light-emitting substrate 100 may include a second conductive layer 160 and a third conductive layer 170 stacked on a side of the substrate 110 in sequence.

For example, there are a plurality of second pad patterns 171 in the third conductive layer 170, and at least two adjacent second pad patterns 171 constitute a second pad group.

It can be understood that, the driver chip 121 includes at least two pins, and the light-emitting device 123 includes two pins. The pins of the driver chip 121 are soldered to the second pad patterns of the second pad group, so as to fix the driver chip 121. The pins of the light-emitting device 123 may also be soldered to the second pad patterns of the second pad group, so as to fix the light-emitting device 123.

The second pad group is used to be electrically connected to the driver chip 121 or the light-emitting device 123.

For example, in the light-emitting substrate, the first voltage lines VL1, the second voltage lines VL2, the third voltage lines VL3, and the third connection line(s) CL3 are all located in the second conductive layer 160; the addressing signal lines DL are located in the third conductive layer 170; and in the light-emitting substrate, the second electrostatic pathway 140, the third voltage signal pins VP3, the third voltage signal pins VP3, the functional pins FP, the dummy pins RP, the second voltage signal pin groups VP2, and the first voltage signal pin groups VP1 are all located in the second conductive layer 160.

With the above arrangement, various signal lines (such as the first voltage lines VL1, the second voltage lines VL2, the third voltage lines VL3, the third connection line(s) CL3 and the addressing signal lines DL), the second pad patterns and various pins are arranged in different conductive layers, which facilitates optimizing the design of the various signal lines, the second pad patterns and the various pins to increase distances between adjacent signal lines, adjacent pads or adjacent pins, thereby avoiding affecting the accuracy of signals transmitted thereon.

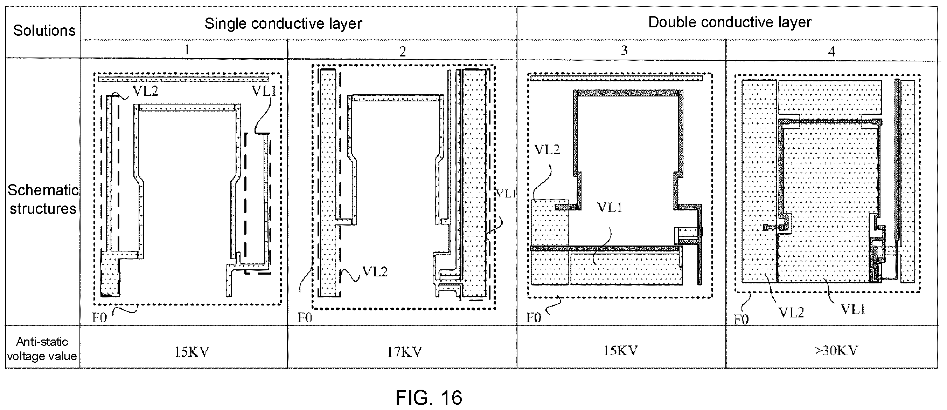

In addition, the inventors of the present disclosure have tested and verified the anti-static ability of the solution in which the device region is filled with the conductive pattern, and the verification results are shown in FIG. 16.

In FIG. 16, the "single conductive layer" means that the light-emitting substrate includes one conductive layer, e.g., the first conductive layer, and the pad patterns and the signal line patterns are located in a same conductive layer; the "double conductive layer" means that the light-emitting substrate includes two conductive layers, e.g., the second conductive layer and the third conductive layer, and the pad patterns and the signal line patterns are located in different conductive layers, respectively.

In FIG. 16, in a case where the light-emitting substrate includes the single conductive layer, in Solution 1, the line width and length of the first voltage line VL1 are relatively small, the line width and length of the second voltage line VL2 are relatively small, and the area occupied by the first voltage line VL1 and the second voltage line VL2 in the device region F0 is relatively small. That is, the pattern proportion of the first conductive layer is small. By testing this solution, the anti-static voltage value of the device region F0 of the light-emitting substrate is 15 kV. In FIG. 16, compared with Solution 1, in Solution 2, the line width and length of the first voltage line VL1 and the line width and length of the second voltage line VL2 are increased, and the filling area of the device region F0 occupied by the first voltage line VL1 and the second voltage line VL2 is relatively large. That is, the pattern proportion of the first conductive layer is relatively large. By testing this solution, the anti-static voltage value of the device region F0 of the light-emitting substrate is 17 kV, which is higher than the anti-static ability of the device region F0 of the light-emitting substrate in Solution 1. It can be seen that, by increasing the line width and length of the first voltage line VL1 in the conductive layer, or increasing the line width and length of the second voltage line VL2 in the first conductive layer, the pattern proportion of the first conductive layer is increased, so that the static electricity generated by CDM may be effectively conducted out, and the anti-static ability of the device region F0 and the light-emitting substrate may be improved.

In FIG. 16, in a case where the light-emitting substrate includes the double conductive layers, the first voltage line VL1 and the second voltage line VL2 are both located in the second conductive layer that is closer to the substrate. In Solution 3, the line width and length of the first voltage line VL1 and the line width and length of the second voltage line VL2 are both relatively small, and the area occupied by the first voltage line VL1 and the second voltage line VL2 in the device region F0 is relatively small. That is, the pattern proportion of the second conductive layer is small. By testing this solution, the anti-static voltage value of the device region F0 of the light-emitting substrate is 15 kV. In FIG. 16, compared with Solution 3, in Solution 4, the line width and length of the first voltage line VL1 and the line width and length of the second voltage line VL2 are increased, and the filling area in the device region F0 occupied by the first voltage line VL1 and the second voltage line VL2 is relatively large. That is, the pattern proportion of the second conductive layer is relatively large. By testing this solution, the anti-static voltage value of the device region F0 of the light-emitting substrate is greater than 30 kV, which is much higher than the anti-static ability of the device region F0 of the light-emitting substrate in Solution 3. It can be seen that, by increasing the line width and length of the first voltage line VL1 in the second conductive layer, or increasing the line width and length of the second voltage line VL2 in the conductive layer, the pattern proportion of the second conductive layer in the device region F0 may be increased, so that the anti-static ability of the light-emitting substrate may be effectively improved, the static electricity of the light-emitting substrate generated by CDM may be conducted out, and the anti-static ability of the device region F0 and the light-emitting substrate may be improved.

The foregoing descriptions are merely specific implementations of the present disclosure, but the protection scope of the present disclosure is not limited thereto. Variations or substitutions that any person skilled in the art would conceive of within the technical scope of the present disclosure shall be included in the protection scope of the present disclosure. Therefore, the protection scope of the present disclosure shall be subject to the protection scope of the claims.

## Claims

1. A light-emitting substrate having a bonding area and a functional area that are arranged along a first direction in sequence, the light-emitting substrate comprising:
a substrate;
a plurality of functional element groups located on a side of the substrate and located in the functional area; and
a first electrostatic pathway located on a same side of the substrate with the plurality of functional element groups, wherein the first electrostatic pathway is electrically connected to the bonding area, a portion of the first electrostatic pathway is located in the functional area, and the first electrostatic pathway is configured to conduct static electricity from the functional area to the bonding area.

2. The light-emitting substrate according to claim 1, wherein the first electrostatic pathway includes a first annular conductive structure and at least one first conductive pattern; the first annular conductive structure includes a first sub-segment, a second sub-segment and a third sub-segment that are electrically connected in sequence; the first sub-segment and the second sub-segment are located on opposite sides of the functional area along a second direction, and the third sub-segment is located on a side of the functional area away from the bonding area; at least a portion of a first conductive pattern is located in the functional area, and an orthographic projection of the first conductive pattern on the substrate does not overlap with orthographic projections of the functional element groups on the substrate, wherein
the first conductive pattern is electrically connected to the third sub-segment; and
the first direction intersects with the second direction.

3. The light-emitting substrate according to claim 2, wherein in a case where there are a plurality of first conductive patterns, in the first direction, two adjacent first conductive patterns are electrically connected, and a first conductive pattern closest to the third sub-segment is electrically connected to the third sub-segment.

4. The light-emitting substrate according to claim 2 or 3, wherein the plurality of first conductive patterns and the first annular conductive structure are made of a same material and arranged in a same layer; and
the third sub-segment and the first conductive pattern electrically connected to the third sub-segment form a one-piece structure.

5. The light-emitting substrate according to any one of claims 2 to 4, wherein the first electrostatic pathway further includes a plurality of bridge portions; and
in any column of first conductive patterns, two adjacent first conductive patterns are electrically connected through a bridge portion.

6. The light-emitting substrate according to claim 5, where at least one of the plurality of bridge portions is a jumper resistor.

7. The light-emitting substrate according to any one of claims 2 to 6, wherein a functional element group includes a driver chip and at least one light-emitting device group, and a light-emitting device group includes at least two light-emitting devices;
the light-emitting substrate further comprises a first connection line connecting the driver chip to the light-emitting device group and a second connection line connecting any two light-emitting devices belong to a same light-emitting device group; and
orthographic projections of the plurality of first conductive patterns on the substrate do not overlap with orthographic projections of the first connection line and the second connection line on the substrate.

8. The light-emitting substrate according to claim 7, wherein the plurality of first conductive patterns, the first connection line and the second connection line are made of a same material and arranged in a same layer.

9. The light-emitting substrate according to claim 1, wherein the first electrostatic pathway includes a plurality of first voltage lines and at least one third connection line, the plurality of first voltage lines extend along the first direction and arranged at intervals along a second direction, and a third connection line is used to connect at least two first voltage lines.

10. The light-emitting substrate according to claim 9, wherein the third connection line is located on a side of the functional area away from the bonding area.

11. The light-emitting substrate according to claim 9 or 10, wherein along the second direction, a (2i-1)-th first voltage line and a 2i-th first voltage line are connected to a same third connection line, and i is a positive integer.

12. The light-emitting substrate according to any one of claims 9 to 11, wherein functional element groups arranged along the first direction are connected to one first voltage line.

13. The light-emitting substrate according to any one of claims 9 to 12, wherein in a case where there are a plurality of third connection lines, the plurality of third connection lines are connected to form a one-piece structure.

14. The light-emitting substrate according to claim 13, wherein the plurality of first voltage lines and the plurality of third connection lines are made of a same material and arranged in a same layer.

15. The light-emitting substrate according to any one of claims 1 and 9 to 14, wherein the plurality of functional element groups are arranged in columns; the functional area includes a plurality of device regions, and a single functional element group is located in one device region;
the first electrostatic pathway includes:
a plurality of second voltage lines, wherein a second voltage line is electrically connected to a column of functional element groups; and
a plurality of second conductive patterns, wherein orthographic projections of the plurality of second conductive patterns on the substrate do not overlap with orthographic projections of the functional element groups on the substrate, wherein
a second conductive pattern is electrically connected to the second voltage line, and at least a portion of the second conductive pattern is located in the device region.

16. The light-emitting substrate according to claim 15, wherein the plurality of second voltage lines and the plurality of second conductive patterns are made of a same material and arranged in a same layer.

17. The light-emitting substrate according to any one of claims 1 and 9 to 16, further comprising:
a plurality of functional pins located in the bonding area; and
a second electrostatic pathway, wherein the second electrostatic pathway is a second annular conductive structure surrounding the functional area, and the second annular conductive structure includes a first sub-portion, a second sub-portion, a third sub-portion and a fourth sub-portion that are electrically connected in sequence; the first sub-portion and the second sub-portion are located on opposite sides of the functional area along a second direction, the third sub-portion is located on a side of the functional area away from the bonding area, and a portion of the fourth sub-portion is located on a side of the bonding area away from the functional area; and the second electrostatic pathway is configured to conduct static electricity from the functional area to the bonding area, wherein
the plurality of functional pins are electrically connected to the portion of the fourth sub-portion located on the side of the bonding area away from the functional area.

18. The light-emitting substrate according to claim 17, wherein the light-emitting substrate further comprises a plurality of second voltage signal pin groups, a plurality of first voltage signal pin groups and a plurality of dummy pins that are located in the bonding area, any one of the plurality of second voltage signal pin groups includes a plurality of second voltage signal pins, and any one of the plurality of first voltage signal pin groups includes a plurality of first voltage pins.

19. The light-emitting substrate according to claim 18, wherein at least one dummy pin is electrically connected to the portion of the fourth sub-portion located on the side of the bonding area away from the functional area.

20. The light-emitting substrate according to claim 18 or 19, wherein the plurality of first voltage signal pin groups and the plurality of second voltage signal pin groups are alternately arranged along the second direction, and at least one dummy pin is disposed between any adjacent first voltage signal pin group and second voltage signal pin group.

21. The light-emitting substrate according to claim 19 or 20, wherein in the first direction, a distance between a dummy pin electrically connected to the fourth sub-portion and the second voltage signal pins of a second voltage signal pin group adjacent to the dummy pin is greater than or equal to 200 µm.

22. The light-emitting substrate according to any one of claims 18 to 21, wherein a distance between two adjacent first voltage signal pins is greater than or equal to 100 µm.

23. The light-emitting substrate according to any one of claims 18 to 22, wherein the second electrostatic pathway, the plurality of functional pins, the plurality of dummy pins, the plurality of second voltage signal pin groups and the plurality of first voltage signal pin groups are made of a same material and arranged in a same layer.

24. A backlight module, comprising the light-emitting substrate according to any one of claims 1 to 23 and an optical film disposed on a light-exit surface of the light-emitting substrate.

25. A display apparatus, comprising: the backlight module according to claim 24;
an array substrate disposed on a light-exit surface of the backlight module; and
a color filter substrate disposed on a side of the array substrate away from the backlight module.
